# EUROPEAN PATENT APPLICATION

(11) **EP 3 996 153 A1**
(43) Date of publication of application: **11.05.2022**
(21) Application number: 20835087.6
(22) Date of filing: 09.04.2020
(51) Int. Cl.: H01L 31/18, H01L 31/0203, H01L 31/048, H01L 31/0216

(54) **METHOD FOR MANUFACTURING GRAPHIC COVER SUBSTRATE FOR SOLAR PANEL, SOLAR PANEL AND MANUFACTURING METHOD THEREFOR**

(30) Priority: 03.07.2019 KR 20190080381
(71) Applicant: LG Electronics Inc., Seoul 07336 (KR)
(72) Inventor: KIM, Chungyi, Seoul 06772 (KR); CHOI, Junghoon, Seoul 06772 (KR); KIM, Jeongkyu, Seoul 06772 (KR)
(74) Representative: Katérle, Axel
(86) International application number: PCT/KR2020/004836
(87) International publication number: WO 2021/002570

(57) **Abstract**

A method for manufacturing a graphic cover substrate for a solar cell panel according to an embodiment of the present disclosure includes applying a cover layer, which is forming the cover layer composed of a ceramic material layer on a transfer member; transferring, which is transferring the cover layer to a base member; and reinforcing, which is forming a cover portion by reinforcing or semi-reinforcing the base member on which the cover layer is formed.

## Description

### [Technical Field]

The present disclosure relates to a method for manufacturing a graphic cover substrate for a solar cell panel, and to a solar cell panel and a method for manufacturing the same, and more particularly, a method of manufacturing a graphic cover substrate for a solar cell panel with improved manufacturing process, and a solar cell panel including a graphic cover substrate for a solar cell panel manufactured thereby and a method for manufacturing therefor.

### [Background Art]

In general, when solar cell panels are applied to buildings, they are installed on rooftops or roofs. However, in apartments or high-rise buildings, since the sizes of the solar cell panels that can be installed on the rooftops or the roofs are limited, it was difficult to use sunlight efficiently. Accordingly, recently, research on solar cell panels having a building-integrated structure that are installed on exterior walls of houses or buildings, etc. and is integrated with the houses, the buildings, etc. has been actively conducted. When the solar cell panels having the building-integrated structure are applied, photoelectric conversion can be made in a large area of the exterior wall of the building, so that sunlight can be effectively used.

However, in order to be applied to the exterior wall of the building, it must have excellent aesthetic characteristics even after the solar cell panel having the building-integrated structure is installed, it is required to diversify the color of the solar cell panel having the building-integrated structure or improve the appearance thereof. However, in the conventional solar cell panel having the building-integrated structure, the solar cell and the wiring connected thereto can be seen from the outside as it is, or they may have only a blue-based color, which is the color of a solar cell, so that it was difficult to improve the aesthetics and appearance. Moreover, when the solar cell panel is used for a long time, yellowing may occur and the appearance of the solar cell panel may be deteriorated. In addition, when the solar cell panel having the building-integrated structure is installed on the exterior wall of the building, especially the vertical wall, glare phenomenon may occur due to the glass substrate positioned in front of the solar cell panel having the building-integrated structure by being installed perpendicular to the floor.

In order to prevent this, when the front surface of the solar cell panel is colored over a certain thickness, the amount of light incident on the solar cell panel is reduced, and the output of the solar cell panel was greatly reduced. As another example, when using a colored film as in Japanese Patent No. 3717369, when viewed from the side or in bright light, the color by the colored film was recognized differently or was recognized separately from other members, thereby degrading the aesthetics. In addition, when coloring or attaching a colored film to a cover member having curves, irregularities, or the like, problems such as non-uniform coloring or damage to the colored film may occur.

### [Detailed Description of Invention]

### [Technical Problem]

The present disclosure is to provide a method for manufacturing a graphic cover substrate for a solar cell panel that has excellent aesthetic uniformity and can prevent glare. The present disclosure is to provide a solar cell panel including a graphic cover substrate for a solar cell panel that has excellent aesthetic uniformity and can prevent preventing glare, and a method for manufacturing the same.

More specifically, the present disclosure is to provide a method for manufacturing a graphic cover substrate for a solar cell panel capable of implementing a desired design by uniformly and stably forming a printed layer by a simple manufacturing process, and a solar cell panel including the same and a manufacturing method thereof

In particular, the present disclosure is to provide a method for manufacturing a graphic cover substrate for a solar cell panel that can be applied to a cover substrate having curves, irregularities, etc. to implement a desired design in response to various types of architectural forms, and a solar cell panel including the same, and a method for manufacturing the same.

### [Technical Solution]

A method for manufacturing a graphic cover substrate for a solar cell panel according to an embodiment of the present disclosure includes applying a cover layer, which is forming the cover layer composed of a ceramic material layer on a transfer member; transferring, which is transferring the cover layer to a base member; and reinforcing, which is forming a cover portion by reinforcing or semi-reinforcing the base member on which the cover layer is formed.

The cover portion may be composed of a ceramic oxide composition including a ceramic frit. The base member may include a glass substrate, and the cover portion may be composed of an integral part constituting a part of the glass substrate.

In the applying the cover layer, the cover layer may be formed by a printing process. For example, in the applying the cover layer, the cover layer may be formed by a digital inkjet printing process. The ceramic material layer may include a particle having a central particle diameter of 50 µm or more.

A thickness of the cover portion may be 20um or less.

The method may further include forming, which is forming the base member between the transferring and the reinforcing.

One surface of the base member on which the cover portion is formed may have a curved, uneven, or protruding portion having a height difference of 5 µm or more.

A method for manufacturing a solar cell panel according to an embodiment of the present disclosure may include a first cover member manufactured by the method for manufacturing a graphic cover substrate for a solar cell panel described above. In this case, a method for manufacturing a solar cell panel according to the present embodiment may include stacking, which is forming a stacked structure by stacking a first cover member, a first sealing material, a solar cell portion, a first sealing material, and a second cover member; and laminating, which is integrating by applying heat and pressure to the stacked structure.

A solar cell panel according to an embodiment of the present disclosure may include a first cover member including a base member having a curved, uneven, or protruding portion on one surface, and a cover portion formed on the one surface of the base member and made of an oxide ceramic composition. The first cover member may be positioned on one surface of the solar cell, and the solar cell panel may further include a solar cell; a sealing material sealing the solar cell; and a second cover member positioned on the other surface of the solar cell on the sealing material.

A difference in height due to the curved, uneven, or protruding portion may be 5 µm or more.

In the cover portion, a first transmittance, which is an average light transmittance of the cover portion with respect to light in an infrared region may be equal to or greater than a second transmittance, which is an average light transmittance of the cover portion with respect to light in a visible light region.

### [Advantageous Effects]

According to the first cover member or the solar cell panel including the same according to the present embodiment, it is possible to have excellent aesthetic uniformity and prevent a glare phenomenon by providing the cover portion. In this case, by forming the cover portion uniformly and stably by a simple manufacturing process that does not change the manufacturing process of the solar cell panel by using a transfer process, the solar cell panel can have a desired design. In addition, by adjusting the thickness, transmittance, print density, printing area, etc. of the cover layer when the cover layer is printed on the transfer member, it is possible to maintain the output above a certain level while improving the aesthetics of the solar cell panel.

In addition, the cover portion can be stably formed on the cover member having various curves, irregularities, and the like. Accordingly, the first cover member or the solar cell panel may have a desired design in response to various types of construction.

### [Description of Drawings]

FIG. 1 is a diagram schematically illustrating an example of a building to which a solar cell panel according to an embodiment of the present disclosure is applied.
FIG. 2 is an exploded perspective view schematically illustrating a solar cell panel according to an embodiment of the present disclosure.
FIG. 3 is a schematic cross-sectional view taken along line III-III of FIG. 2.
FIG. 4 is a plan view schematically illustrating a first cover member included in a solar cell panel shown in FIG. 2.
FIG. 5 is a graph illustrating a light transmittance according to a wavelength of a cover portion included in a solar cell panel according to an embodiment of the present disclosure according to color.
FIG. 6 is a flowchart illustrating an example of a method of manufacturing a first cover member according to an embodiment of the present disclosure.
FIG. 7 is a flowchart illustrating an example of a cover layer forming step included in a method of manufacturing a first cover member shown in FIG. 6.
FIGS. 8A to 8E are cross-sectional views illustrating each step of a manufacturing method of a first cover member illustrated in FIG. 6.
FIGS. 9A to 9C are diagrams schematically illustrating a method of manufacturing a solar cell panel 100 according to an embodiment of the present disclosure.
FIG. 10 is a schematic cross-sectional view of a solar cell panel according to another embodiment of the present disclosure.
FIG. 11 is a flowchart illustrating an example of a method of manufacturing a first cover member according to another embodiment of the present disclosure.
FIGS. 12A to 12C are cross-sectional views illustrating each step of a method of manufacturing a first cover member illustrated in FIG. 11.
FIG. 13 is a schematic partial cross-sectional view of a first cover member included in a solar cell panel according to another embodiment of the present disclosure.
FIG. 14 is a schematic partial cross-sectional view of a first cover member included in a solar cell panel according to another embodiment of the present disclosure.

### [Mode for Invention]

Hereinafter, embodiments of the present disclosure will be described in detail with reference to the accompanying drawings. However, it is needless to say that the present disclosure is not limited to these embodiments and can be modified into various forms.

In the drawings, illustration of the parts not related to the description is omitted in order to clarify and briefly describe the present disclosure, and the same reference numerals are used for the same or very similar parts throughout the specification. In the drawings, the thickness, width, and the like are enlarged or reduced to make the explanation more clear, and the thickness, width, etc. of the present disclosure are not limited to those shown in the drawings.

When a part is referred to as "including" another part throughout the specification, it does not exclude other parts and may further include other parts unless specifically stated otherwise. Further, when a part of a layer, a film, a region, a plate, or the like is referred to as being "on" other part, this includes not only the case where it is "directly on" the other part but also the case where the other part is positioned in the middle. When the part of the layer, the film, the region, the plate, or the like is referred to as being "directly on" the other part, it means that no other part is positioned in the middle.

Hereinafter, a method for manufacturing a graphic cover substrate for a solar cell panel, and a solar cell panel and a method for manufacturing the same according to an embodiment of the present disclosure will be described in detail with reference to the accompanying drawings.

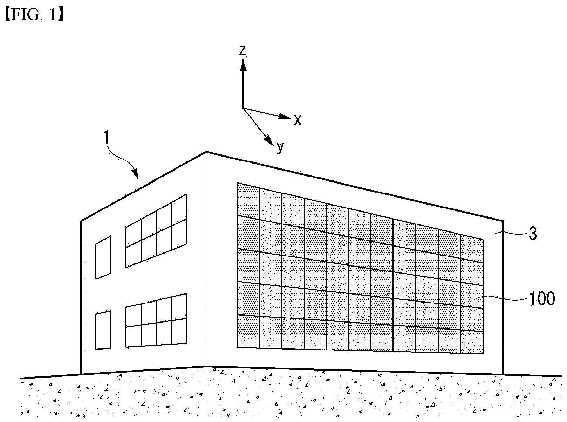

FIG. 1 is a diagram schematically illustrating an example of a building 1 to which a solar cell panel 100 according to an embodiment of the present disclosure is applied.

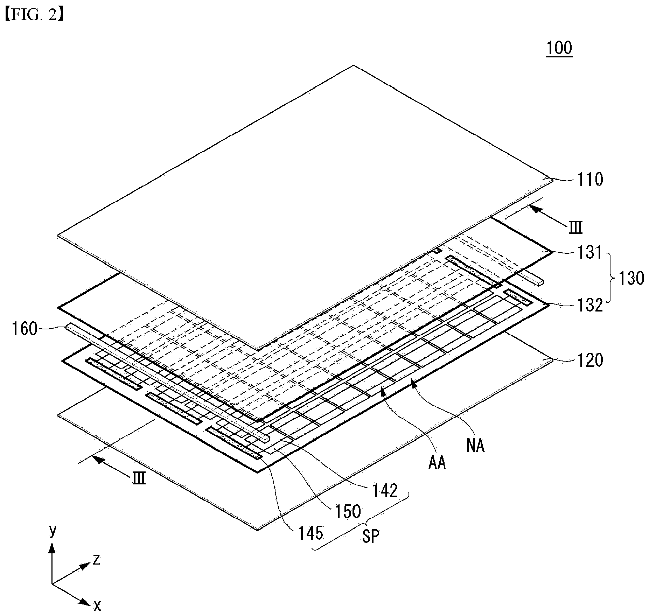

Referring to FIG. 1, the solar cell panel 100 according to the present embodiment may be, for example, a solar cell panel having a building-integrated structure applied to an exterior wall surface (e.g. vertical wall 3, roof surface, etc.) of the building 1. However, the present disclosure is not limited thereto, and the solar cell panel 100 may be installed on the roof of the building 1 or other places other than the building 1. The solar cell panel 100 includes a solar cell (reference numeral 150 in FIG. 2) and may generate power using sunlight supplied from the sun.

In the present embodiment, the solar cell panel 100 may include a graphic cover substrate (e.g. a first cover member (reference numeral 110 in FIG. 2, hereinafter the same)) having a certain color, image, pattern, feeling, texture, or the like, or provided with a certain figure, letter, or the like. As described above, the aesthetics of the solar cell panel 100 and the building 1 including the same may be improved by the color of the graphic cover substrate. However, it is possible to minimize or prevent a decrease in the solar conversion efficiency of the solar cell panel 100 by preventing a large loss of sunlight due to the graphic cover substrate. The solar cell panel 100 will be described in more detail with reference to FIGS. 2 to 5 together with FIG. 1.

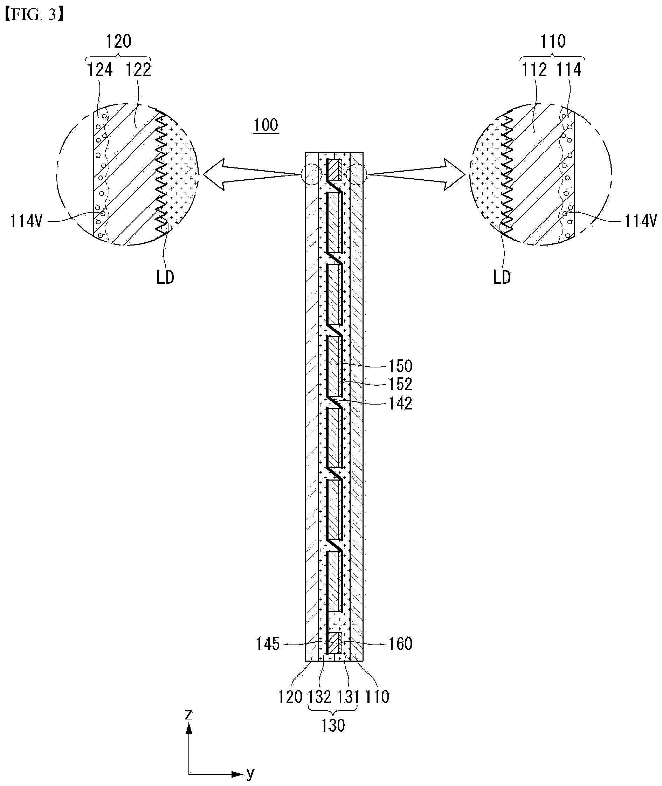

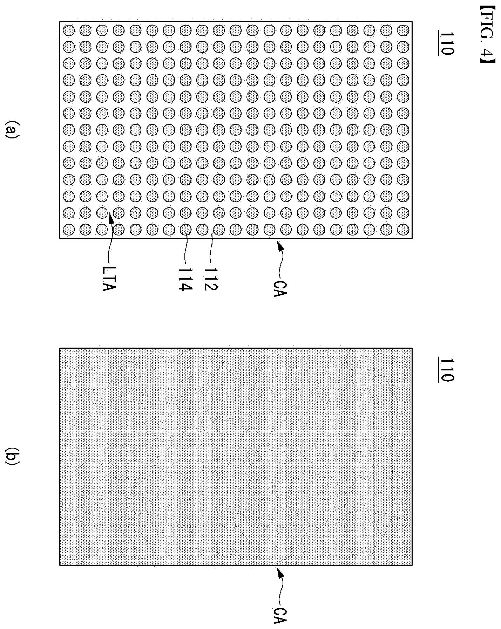

FIG. 2 is an exploded perspective view schematically illustrating a solar cell panel 100 according to an embodiment of the present disclosure, and FIG. 3 is a schematic cross-sectional view taken along line III-III of FIG. 2. And FIG. 4 is a plan view schematically illustrating a first cover member 110 included in the solar cell panel 100 shown in FIG. 2. For simplicity and clarity of illustration, the first cover member 110 and a second cover member 120 are briefly illustrated in FIG. 2, and a cover portion 114 and a cover part 124 are not illustrated. In addition, the structure of a solar cell 150 is not illustrated in detail in FIG. 3, and only an anti-reflection layer 152 formed on the front surface is schematically illustrated.

Referring to FIGS. 2 to 4, the solar cell panel 100 according to the present embodiment may include a solar cell portion SP including the solar cell 150 and wiring portions 142 and 145 connected thereto, a sealing material 130 surrounding and sealing the solar cell portion SP, the first cover member (front member) 110 having the cover portion 114 positioned on one surface (e.g. a front surface) of the solar cell portion SP on the sealing material 130 and implementing a specific color, image, pattern, feeling, or texture, and the second cover member (rear member) 120 positioned on the other surface (e.g. a rear surface) of the solar cell portion SP on the sealing material 130. Here, at least one of the first cover member 110 and the second cover member 120 (in particular, the first cover member 110) may be a graphic cover substrate having a color or the like. In addition, a coloring member 160 for covering at least a part of the wiring portions 142 and 145 from the front surface of the solar cell portion SP may be further included.

In this case, the solar cell 150 may include a photoelectric conversion unit that converts the solar cell into electrical energy, and an electrode electrically connected to the photoelectric conversion unit to collect and transmit current. For example, the solar cell 150 may be a solar cell that generates electrical energy from light in a wavelength range of at least 90 nm to 1400 nm (e.g. 100 nm to 1200 nm). In the present embodiment, as an example, the photoelectric conversion unit may be composed of a crystalline silicon substrate (e.g. a silicon wafer) and a conductive region formed in or on the crystalline silicon substrate and including a dopant or including an oxide. As described above, the solar cell 150 based on the crystalline silicon substrate having high crystallinity and few defects has excellent electrical characteristics.

And in the present embodiment, a plurality of solar cells 150 are provided while being spaced apart from each other, and the plurality of solar cells 150 may be electrically connected in series, parallel or series-parallel by the wiring portions 142 and 145. For example, the plurality of solar cells 150 may be connected in series by a wiring member 142 to form a solar cell string extending long in a first direction (z-axis direction in the drawing). In addition, a bus ribbon 145 extending in a second direction (x-axis direction in the drawing) intersecting the first direction may be provided at an end of the solar cell string. For example, the bus ribbon 145 may be connected to both ends of the wiring member 142 of the solar cell string. The bus ribbon 145 may connect adjacent solar cell strings in the second direction in series, parallel, or series-parallel, or connect the solar cell strings to a junction box that prevents reverse current. As the wiring member 142, various structures and shapes capable of connecting the solar cells 150 such as ribbons and wires may be applied. In addition, the material, shape, connection structure, etc. of the bus ribbon 145 may be variously modified. The present embodiment is not limited to the number, structure, shape, etc. of the wiring portions 142 and 145 used in each solar cell 150.

However, the present disclosure is not limited thereto, and the structure and method of the solar cell 150 may be variously modified. For example, the solar cell 150 may have various structures such as a compound semiconductor solar cell, a silicon semiconductor solar cell, and a dye-sensitized solar cell. And it is also possible that only one solar cell 150 is provided.

In the present embodiment, the anti-reflection layer 152 is positioned on the front surface of the solar cell 150 to prevent light from being incident, and the solar cell 150 may have a certain color (e.g. blue, black, etc.) due to constructive interference by the anti-reflection layer 152. In addition, the wiring portions 142 and 145 may be made of metal. Accordingly, when the first cover member 110 is provided with only a glass substrate, a boundary between an effective area AA in which the solar cell 150 is positioned and a non-effective area NA in which the solar cell 150 is not positioned, and the wiring portions 142 and 145 positioned in the non-effective area NA may be easily recognized. In particular, the wiring portions 142 and 145 (e.g. bus ribbon 145) having a wide portion having a width of 1 mm or more may be recognized more easily. Then, the aesthetics of the solar cell panel 100 may be deteriorated. Accordingly, in the present embodiment, the first cover member 110 is provided with the cover portion (appearance forming portion) 114 and the coloring member 160 is further provided, which will be described in detail later.

For example, the antireflection layer 152 of the solar cell 150 may have a structure in which a plurality of insulating layers including oxide, nitride, carbide (e.g. silicon oxide, silicon nitride, or silicon carbide), silicate including silicon, or amorphous silicon are stacked. Alternatively, the antireflection layer 152 of the solar cell 150 may have a structure in which a plurality of insulating layers formed of an oxide or nitride oxide including silicon, titanium, aluminum, zirconium, zinc, antimony, and copper are stacked. When the antireflection layer 152 is made of oxide or nitride oxide, a layer including silicon nitride and/or a layer including silicon carbon nitride are further provided inside or outside the anti-reflection layer 152 to prevent problems caused by ultraviolet rays, moisture, etc. However, the present disclosure is not limited thereto, and the anti-reflection layer 152 may have various materials, stacked structures, and the like.

The first cover member 110 is positioned on the sealing material 130 (e.g. a first sealing material 131) to constitute one surface (e.g. a front surface) of the solar cell panel 100, and the second cover member 120 is positioned on the sealing material 130 (e.g. a second sealing material 132) to constitute the other surface (e.g. a rear surface) of the solar cell panel 100. Each of the first cover member 110 and the second cover member 120 may be made of an insulating material capable of protecting the solar cell 150 from external impact, moisture, ultraviolet rays, and the like. Specific structures of the first and second cover members 110 and 120 will be described in detail later.

The sealing material 130 may include the first sealing material 131 positioned between the solar cell portion SP and the first cover member 110 and the first and second sealing materials 131 and 132 positioned between the solar cell portion SP and the second cover member 120. The first sealing material 131 and the second sealing material 132 prevent the inflow of moisture and oxygen, and chemically bond each element of the solar cell panel 100. The first and second sealing materials 131 and 132 may be formed of an insulating material having light-transmitting properties and adhesive properties. For example, as the first sealing material 131 and the second sealing material 132, ethylene vinyl acetate copolymer resin (EVA), polyvinyl butyral, silicon resin, ester-based resin, olefin-based resin (e.g. polyolefin), etc. may be used. The second cover member 120, the second sealing material 132, the solar cell portion SP including the solar cell 150 and the wiring portions 142 and 145, the coloring member 160, the first sealing material 131, and the first cover member 110 are integrated by a lamination process or the like to form the solar cell panel 100.

However, the present disclosure is not limited thereto. Accordingly, the first and second sealing materials 131 and 132 may include various materials other than those described above and may have various shapes.

In the present embodiment, the first and second cover members 110 and 120 may be graphic cover substrates that allow the solar cell panel 100 to have a desired appearance such as a certain color, image, pattern, feeling, texture, etc., or may have a certain structure that can prevent the solar cell 150 or the wiring portions 142 and 145 connected thereto from being clearly recognized.

The first cover member 110 may have a light-transmitting property through which light may pass so as not to block the light incident to the solar cell 150. More specifically, the first cover member 110 may include a first base member 112 and the cover portion 114 formed on the first base member 112 and made of an oxide ceramic composition to form a desired appearance. The cover portion 114 may serve to prevent the solar cell 150 or the wiring portions 142 and 145 connected thereto from being clearly recognized while allowing the solar cell panel 100 to have a desired appearance.

And the second cover member 120 may have excellent fire resistance and insulation. More specifically, the second cover member 120 may include a second base member 122 and the cover part 124 formed on the second base member 122. The cover part 124 may serve to prevent the solar cell 150 or the wiring portions 142 and 145 connected thereto from being clearly recognized.

In this case, the first base member 112 may be made of a material having excellent light transmittance (e.g. transparent). For example, the first base member 112 may be a substrate, a film, a sheet, or the like made of glass, resin (e.g. polycarbonate, etc.). The first base member 112 may be composed of a single layer or a plurality of layers. In addition, the second base member 122 may be made of a material having excellent fire resistance and insulating properties. The second base member 122 may be a substrate, a film, a sheet, or the like made of glass, resin, or the like.

In particular, each of the first and second base members 112 and 122 may be formed of a glass substrate having excellent transparency, excellent insulating properties, stability, durability, fire resistance, and the like. For example, each of the first and second base members 112 and 122 may be a low-iron glass substrate (e.g. low iron strengthened glass substrate) having a light transmittance of 80% or more (e.g. 85% or more) with respect to light having a wavelength of 380 nm to 1200 nm. As described above, when the low-iron glass substrate containing a small amount of iron is used, it is possible to prevent reflection of sunlight and increase the transmittance of sunlight. In addition, when the low iron strengthened glass substrate is used, it is possible to effectively protect the solar cell 150 from external impact.

At this time, when the solar cell panel 100 is used as an exterior material of the building 1, the first or second cover members 110 and 120 or the solar cell panel 100 must have sufficient strength to withstand external impacts such as wind pressure, hail, and snow load. To this end, the first or second cover member 110, 120 or the first or second base member 112, 122 may have a deflection of 5 mm or less that occurs in the direction of receiving a force when a force of 2400 Nm² is applied. If the above-described deflection occurs in excess of 5 mm, the durability against the external impacts such as wind pressure, hail, and snow load is not sufficient, so it may be difficult to use as an exterior material of the building 1.

For example, the first or second base members 112 and 122 may have a thickness of 2.8 mm or more, for example, 2.8 mm to 12 mm (more specifically, 2.8 mm to 8 mm), and may have an area of 0.04 to 10 m². If the thickness of the first or second base members 112 and 122 is less than 2.8 mm, it may be difficult for the solar cell panel 100 to withstand external impact or to have sufficient durability to be applied to the building 1. If the thickness of the first or second base members 112 and 122 exceeds 12 mm, since the weight of the solar cell panel 100 is increased, it may be difficult to be applied to the building 1. The area of the above-described first or second base member 112 or 122 is limited in consideration of structural stability, productivity, etc. of the solar cell panel 100.

However, the present disclosure is not limited thereto, and the value, thickness, area, etc. of the deflection of the first or second base members 112 and 122 may have various values.

In the present embodiment, the cover portion 114 may be formed on the first base member 112. Here, the cover portion 114 is a part formed to allow the solar cell panel 100 to have a desired color, image, pattern, feeling, texture, or the like, or to express a figure, character, or the like. The cover portion 114 may have a certain color by having an achromatic color such as white, gray, or black, or a chromatic color such as red, yellow, green, or blue. Alternatively, the cover portion 114 may exhibit a transparent or translucent characteristic, a matte or glossy characteristic, or have a texture different from that of the first base member 112 made of a glass substrate to prevent glare. The cover portion 114 may also serve to prevent the solar cell 150 or the wiring portions 142 and 145 connected thereto, etc. from being clearly recognized from the outside. The cover part 124 may be formed on the second base member 122. The cover part 124 may have a color that can prevent the solar cell 150 or the wiring portions 142 and 145 connected thereto, etc. from being clearly recognized from the outside.

In the present embodiment, the cover portion 114 and/or the cover part 124 may be formed of an oxide ceramic composition. For example, the cover portion 114 may be formed to correspond to a portion in the thickness direction on one surface of the first base member 112, and the cover part 124 may be formed to correspond to a portion in the thickness direction on one surface of the second base member 122.

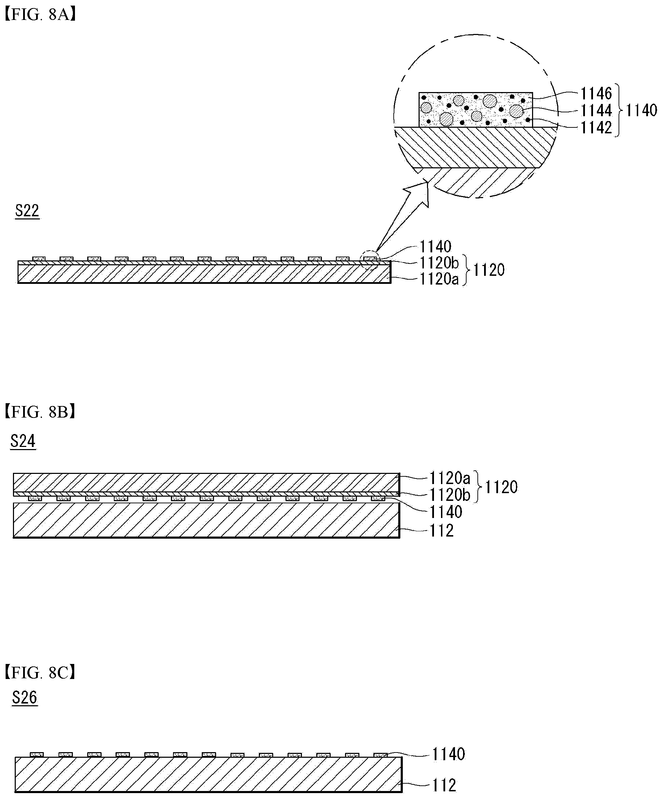

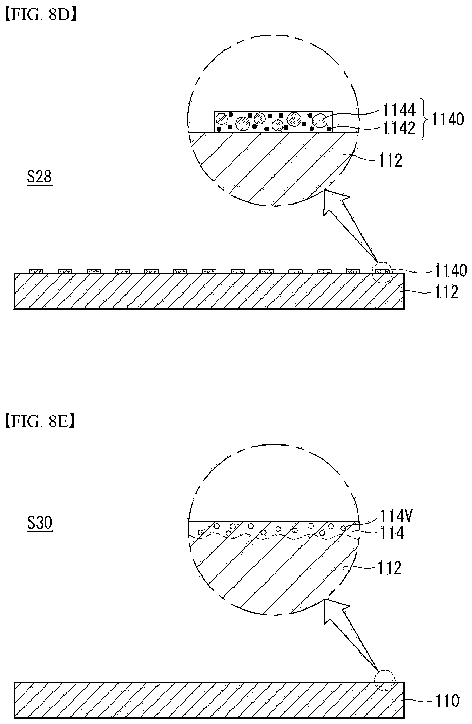

More specifically, in the present embodiment, the first cover member 110 may include the first base member 112 composed of a strengthened or semi-strengthened glass substrate, and the cover portion 114 composed of an integral part constituting a part of the strengthened or semi-strengthened glass substrate including a ceramic frit 1144, etc. inside the strengthened or semi- strengthened glass substrate. That is, the cover portion 114 may be a part of the strengthened or semi-strengthened glass substrate constituting the first base member 112 and a part including a different material (for example, ceramic oxide composition having an amorphous glass structure) from that of the first base member 112. The cover portion 114 may be formed by diffusing and penetrating a ceramic frit (reference numeral 1144 in FIG. 8d, hereinafter the same), a dye (reference numeral 1142 in FIG. 8d, hereinafter the same), and the like into the interior of the first base member 112, and mixing with the material of the glass substrate in the process of strengthening or semi-strengthening the glass substrate constituting the first base member 112. Accordingly, since the cover portion 114 is formed integrally with the first base member 112, physical durability and chemical durability may be excellent. The cover portion 114 may be formed by a cover layer (reference numeral 1140 in FIG. 8, hereinafter the same) including the ceramic frit 1144, the dye 1142, a resin, (reference numeral 1146 in FIG. 8d, hereinafter the same) and the like, and the cover layer 1140 and the ceramic frit 1144, the dye 1142, and the resin 1146 included therein will be described in more detail later in the manufacturing method.

More specifically, the oxide ceramic composition constituting the cover portion 114 may have an amorphous glass structure. For example, the cover portion 114 may be formed of a glassy oxide ceramic composition. The cover portion 114 may be formed by including a plurality of metal compounds (for example, metal oxide) including a plurality of metals and non-metals (for example, oxygen) included in the ceramic frit 1144 and/or the dye 1142, and may have an oxygen polyhedron having a random network structure including a plurality of metals and oxygen, a glass structure, a random network structure, and the like. Whether the cover portion 114 is provided in the form of an oxide ceramic composition may be determined by X-ray photoelectron spectroscopy (XPS) or the like.

As described above, the oxide ceramic composition having an amorphous glass structure may have an amorphous glass structure by being heat-treated at a temperature lower than a temperature for forming a general oxide ceramic. That is, the oxide ceramic composition having an amorphous glass structure may not include a crystalline portion or may only partially include the crystalline portion. Here, in the oxide ceramic composition having an amorphous glass structure, the amorphous portion may be included in the same amount as the crystalline portion or more than the crystalline portion, and in particular, the amorphous portion may be included more than the crystalline portion. For example, the oxide ceramic composition having an amorphous glass structure may have a crystallinity of 50% or less (more specifically, less than 50%, for example, 20% or less). For reference, the conventional oxide ceramic refers to an inorganic non-metal material produced at high temperature and high pressure as an oxide in which ionic bonds, covalent bonds, or combinations thereof are mixed. These oxide ceramics are heat-treated at a high temperature of 850° C or higher (e.g. around 1400° C) and under a high pressure, and most of them have a crystallized state.

The cover portion 114 may include the ceramic frit 1144 as a basic material (for example, the material containing the most, the material containing 50 parts by weight or more). In addition, the cover portion 114 may further include the dye 1142, additives, etc. added as necessary. In addition, since the resin 1146 included in the cover layer 1140 may volatilize during the heat treatment in the glass strengthening step S30, the cover portion 114 may or may not include the resin 1146. Even when the dye 1142 is included in the cover portion 114, the distinction between the ceramic frit 1144 and the dye 1142 of the cover portion 114 may not be clear. For example, the metal of the material included in the dye 1142 may exist in a form included as a metal such as an oxygen polyhedron, a glass structure, a random network structure, etc. constituting the ceramic frit 1144. As described above, the ceramic frit 1144, etc. included in the cover portion 114 may be determined by various component analysis methods (e.g. scanning electron microscope-energy dispersive spectroscopy (SEM-EDX), etc.).

The first cover member 110 according to the present embodiment may implement a desired appearance by the cover portion 114. For example, the appearance and transmittance of the first cover member 110 may be adjusted by adjusting the color, material, area ratio, thickness, etc. of the cover portion 114, or by adjusting the material, size, concentration, density, etc. of the ceramic frit 1144 and the dye 1142, etc. included in the cover portion 114. In the present embodiment, the cover portion 114 may have a light transmittance that is lower than that of the first base member 112 but is constant to transmit a part of sunlight. Then, since the sunlight may be transmitted through the cover portion 114, it is possible to prevent or minimize light loss due to the cover portion 114. For example, the cover portion 114 or the first cover member 110 having the same may have a light transmittance of 10% or more (for example, 10% to 95%, more specifically, 20% to 95%) with respect to light having a wavelength of 380 nm to 1200 nm. However, the present disclosure is not limited thereto. Accordingly, the light transmittance may have various values depending on the color, material, formation area, and the like of the cover portion 114.

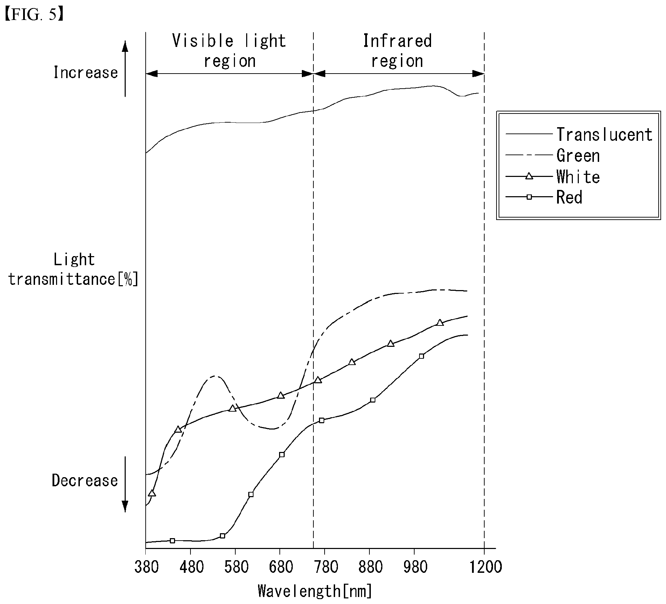

In addition, the cover portion 114 according to the present embodiment is composed of an oxide ceramic composition (in particular, an oxide ceramic composition having an amorphous glass structure) and has a specific light transmittance shape and surface roughness according to wavelength, so even if the light transmittance is somewhat lowered by the cover portion 114, it is possible to prevent or minimize the decrease in the output of the solar cell panel 100. This will be described in detail with reference to FIG. 5 together with FIGS. 1 to 4.

FIG. 5 is a graph illustrating a light transmittance according to a wavelength of a cover portion 114 included in a solar cell panel 100 according to an embodiment of the present disclosure according to color.

As shown in Figure 5, in the cover portion 114 composed of an oxide ceramic composition having an amorphous glass structure in the present embodiment, a first transmittance, which is an average light transmittance for light in the infrared region, is equal to or greater than a second transmittance, which is an average light transmittance for light in the visible light region. In particular, in the cover portion 114 made of the oxide ceramic composition having an amorphous glass structure, the first transmittance may be greater than the second transmittance. In addition, in the cover portion 114 composed of an oxide ceramic composition having an amorphous glass structure, a third transmittance, which is an average light transmittance for light in the ultraviolet region, may be smaller than the first and second transmittances, which are the average light transmittances for light in the infrared region and visible light region, respectively. Here, light in the ultraviolet region may be defined as light having a wavelength of 100 nm to 380 nm, light in the visible ray region may be defined as light having a wavelength of 380 nm to 760 nm, and light in the infrared region may be defined as light having a wavelength of 760 nm to 1200 nm. In addition, the average light transmittance may be defined as an average of normalized transmittance so as not to reflect the light transmittance of the first base member 112.

As shown in FIG. 5, although there is a difference depending on the color, it can be seen that a tendency of the first transmittance to be equal to or greater than that of the second transmittance is maintained. This tendency may be implemented by the heat treatment temperature, cooling rate, etc. in the glass strengthening step (S30).

As described above, when the first transmittance is equal to or greater than the second transmittance, even when the cover portion 114 is provided, the amount of light in the infrared region may be equal to or greater than the amount of light in the visible region among the light passing through the first cover member 110 and reaching the solar cell 150. Accordingly, even when the light transmittance is slightly lowered by the cover portion 114, a large amount of light in the infrared region reaches the solar cell 150, so that it can be effectively used. Accordingly, even when the light transmittance is slightly lowered by the cover portion 114, a decrease in the photoelectric conversion efficiency of the solar cell 150 or the output of the solar cell panel 100 may be prevented or minimized.

And as described above, the first and second transmittances may be greater than the third transmittance, respectively. This is because the cover portion 114 has a higher refractive index than the first base member 112 composed of a glass substrate including the ceramic frit 1144, the dye 1142, an additive, and the like and has a higher extinction coefficient than the first base member 112 composed of a glass substrate according to a material. Light in the ultraviolet region may not significantly contribute to the photoelectric conversion efficiency of the solar cell 150 and the output of the solar cell panel 100, and may have a high photon energy and may cause deformation or change in properties of the solar cell 150, the sealing material 130, and the like. In the present embodiment, the cover portion 114 scatters, blocks, or absorbs light in the ultraviolet region, thereby lowering the light transmittance of the light in the ultraviolet region. Accordingly, while the photoelectric conversion efficiency of the solar cell 150 and the output of the solar cell panel 100 are not significantly affected, it is possible to minimize deformation and change in characteristics of the solar cell 150 and the sealing material 130 that may be caused by ultraviolet rays.

For example, in the present embodiment, in the cover portion 114, the first transmittance may be greater than the second transmittance by 2% or more. Alternatively, a first difference between the first transmittance and the second transmittance may be greater than a second difference between the second transmittance and the third transmittance. In this case, the solar cell panel 100 may more effectively use light in the infrared region. The above-described light transmittance may be measured by various methods, and may be measured by a method capable of measuring both transmittance of vertical light (normal transmittance) and transmittance of scattered light (diffused transmittance). For example, light transmittance may be measured by standard measurement methods such as ISO 9050:2003, BS EN 14500:2008, and the like.

The spectral response (i.e. short-circuit current density (Isc) or output generated at a specific wavelength of light) and quantum efficiency of the solar cell 150 based on monocrystalline silicon in light in the infrared region are high. In the present embodiment, the average light transmittance of light in the infrared region having the high spectral response and quantum efficiency is improved, so that even when the light transmittance is slightly lowered by the cover portion 114 that implements a specific color, feeling, texture, etc., the light in the infrared region can be effectively used. Accordingly, even when the cover portion 114 is formed, the photoelectric conversion efficiency of the solar cell 150 or the output of the solar cell panel 100 may be maintained at a high value. Since light in the ultraviolet region has very low spectral response and quantum efficiency, even if the third transmittance of the cover portion 114 is low, the photoelectric conversion efficiency of the solar cell 150 or the output of the solar cell panel 100 is not significantly affected.

In the present embodiment, the cover portion 114 may not have an air bubble 114V, and the cover portion 114 may have the air bubble 114V to have porosity. In the heat treatment process (for example, glass strengthening step (S30)) for forming the cover portion 114, the resin 1146 or the additive provided in the ceramic material layer or the cover layer 1140 may volatilize, and the air bubble 114V may remain in the corresponding portion. When the air bubble 114V exists inside the cover part 114, light incident on the solar panel 100 may be dispersed in the air bubble 114V and spread widely. More specifically, when the cover portion 114 includes the air bubble 114V, the normal transmittance and the diffused transmittance occur together, resulting in a hemispherical transmittance. Accordingly, the light may be scattered so that the air bubble 114V of the cover portion 114 has a hemispherical transmission shape incident into the solar cell panel 100. Then, some of the light that may be lost toward the region between the solar cells 150 may be directed toward the solar cell 150 and used, or may be reused by the interface between the cover portion 114 and the base member 112. Therefore, even when the cover portion 114 is provided, the photoelectric conversion efficiency of the solar cell 150 and the output of the solar cell panel 100 may be maintained high by maximizing the amount of light used for photoelectric conversion. For example, at least a part of the cover portion 114 may be positioned in a portion corresponding to the region between the solar cells 150. In addition, the air bubble 114V of the cover portion 114 scatters light to have a hemispherical transmission shape toward the outside of the solar cell panel 100 to improve anti-glare properties. For example, an air bubble 114V having a size of 0.1 µm or more may be provided. The effect of the air bubble 114V may be maximized at the size of the air bubble 114V.

When the particles of the ceramic material layer constituting the cover portion 114 or the material constituting the cover layer 1140 have a small particle diameter, the manufacturing process may be simplified and manufacturing cost may be reduced. To this end, the ceramic material layer or the cover layer 1140 may not include a specific additive, and in this case, the air bubble 114V may not be provided in the cover portion 114.

The size, area ratio, presence, etc. of the air bubble 114V may vary depending on the material of the ceramic material layer, the cover layer 1140, or the cover portion 114 (or the dye 1142 contained therein, the ceramic frit 1144, the resin 1146, additives, etc.), the manufacturing method, process conditions, etc. of the ceramic material layer, the cover layer 1140, or the cover portion 114.

In the present embodiment, the surface roughness of the boundary portion (that is, the interface of the cover portion 114) between the first base member 112 and the cover portion 114 in the portion where the cover portion 114 is formed may be greater than the surface roughness of other portions of the first base member 112 where the cover portion 114 is not formed. That is, as shown in the enlarged circle of FIG. 3, in the first cover member 110, the surface roughness of the boundary portion constituted by one surface of the cover portion 114 and the first base member 112 may be greater than the surface roughness of the other surface or the side surface of the first base member 112. This is because the surface roughness may be relatively large at the interface portion with the first base member 112, when the cover portion 114 is formed, while the ceramic frit 1144, the dye 1142, etc. are mixed into the inside of the first base member 112 or materials are moved for phase equilibrium.

As an example, FIG. 3 illustrates that a light diffusion portion LD is positioned on the other surface on which the cover portion 114 is not formed. The light diffusion portion LD may diffuse light to prevent recognition of the solar cell 150 and the like as much as possible, and may improve unity of colors and the like by the cover portion 114. For example, when the light diffusion portion LD is formed in contact with the sealing material 130, an adhesion area with the sealing material 130 may be increased to improve adhesive strength. For example, the light diffusion portion LD may have a size of 10 to 500 µm, and may have various shapes such as a round shape (e.g. a shape corresponding to a part of a sphere), an angular shape, and a pyramid shape. The above-described light diffusion portion LD may have a protruding shape in an embossed shape, or a concave shape in an intaglio shape.

In this case, the size of the light diffusion portion LD may be equal to or greater than the surface roughness of the boundary portion where the cover portion 114 is formed (for example, it may be greater). Here, the size of the light diffusion portion LD may mean a distance between the uppermost end and the lowermost end of the light diffusion portion LD. Accordingly, the diffusion effect by the light diffusion portion LD may be improved. In addition, the surface roughness of the boundary portion where the cover portion 114 is formed may be equal to or greater than the surface roughness of the light diffusion portion LD (for example, it may be greater). Here, the surface roughness of the light diffusion portion LD may mean a surface roughness of the outer surface constituting the shape of the light diffusion portion LD. This is because the light diffusion portion LD is formed through a specific processing process to have a certain shape, and thus the outer surface of the light diffusion portion LD has a relatively small surface roughness.

And although the outer surface of the cover portion 114 is flatly illustrated in FIG. 3 and the like, the present disclosure is not limited thereto. The outer surface of the cover portion 114 may have irregularities, bends, etc. to correspond to the irregularities and bends of the boundary portion between the cover portion 114 and the first base member 112, and the outer surface of the cover portion 114 may have a surface roughness equal to or similar to that of the boundary portion between the cover portion 114 and the first base member 112, so that it may be greater than a surface roughness of other portions of the first base member 112.

Due to the high surface roughness at the interface of the cover portion 114, the cover portion 114 may effectively induce light scattering. In particular, when the cover portion 114 is positioned in a portion (i.e. non-effective area NA) corresponding between the solar cells 150, light due to scattering from the cover portion 114 may be used for photoelectric conversion toward the solar cell 150. Accordingly, the photoelectric conversion efficiency of the solar cell 150 and the output of the solar cell panel 100 may be maintained high.

The above-described cover portion 114 may have a refractive index greater than that of the first base member 112 or the sealing material 130 (for example, a refractive index of 1.48 or more). In addition, the cover portion 114 may have a thickness of 20 µm or less, and may have a thickness of 1 µm or more. The thickness of the cover portion 114 may vary according to the manufacturing process of the cover portion 114. When the thickness of the cover portion 114 exceeds 20 µm, the light transmittance may decrease as a whole, and phenomena such as peeling and cracking of the cover portion 114 may occur. In addition, since the cover portion 114 may serve to relieve tensile stress in the glass strengthening step S30, when the thickness of the cover layer 1140 or the cover portion 114 is increased, the strengthening of the first base member 112 may not be performed as desired. If the thickness of the cover portion 114 is less than 1 µm, it may be difficult to implement a desired appearance, and when the dye 1142 is included, the density of the dye 1142 is lowered, so that it may be difficult to display a desired color. For example, the thickness of the cover portion 114 may be 4 µm or more to sufficiently implement the effect of the cover portion 114, and in order to simplify the manufacturing process of the cover portion 114 and reduce material cost, the thickness of the cover portion 114 may be 10 µm or less. However, the present disclosure is not limited thereto. In addition, the thickness of the cover portion 114 may be adjusted according to the color, for example, when the cover portion 114 has a white color having a relatively low light transmittance, it may have a smaller thickness than the cover portion 114 of other colors.

On the other hand, in the conventional layer formed on the first cover member 110, the light transmittance of light in the infrared region is low, and the amount of light in the infrared region in the light reaching the solar cell is less than the light in the visible region, so that it was difficult to effectively use light in the infrared region. For example, the anti-reflection layer for preventing reflection has the highest light transmittance at a corresponding wavelength to prevent reflection of light having a short wavelength of about 600 nm, where the intensity of sunlight is strongest. Conventionally, even when the layer (for example, the anti-reflection layer) provided on the first cover member 110 is made of the same or similar material as the cover portion 114, when it does not have a ceramic shape, the average light transmittance for light in the infrared region is smaller than the average light transmittance to light in the visible region. In addition, the anti-reflection layer has a refractive index of about 1.3 that is smaller than that of the first base member 112 and the sealing material 130 and has a thickness of 500 nm or less (for example, around 200nm). Accordingly, it has different characteristics from the cover forming layer 114 of the present embodiment, and it is difficult to effectively use light in the infrared region. In addition, in most cases, since the formation of a layer (e.g. an anti-reflection layer) provided on the first cover member 110 is made by laminating it on the first cover member 112, the surface roughness at the interface of the layers (e.g. the anti-reflection layer) provided on the first cover member 110 is not different from that of other portions.

In FIG. 4, the cover portion 114 is provided only in a part of a cover area CA in the first cover member 110, and when viewed from a distance spaced apart by a certain distance, it may be recognized that the cover portion 114 has the same appearance over the entire cover area CA. Here, the cover area CA means an area recognized as having the same color, image, pattern, feeling, texture, etc. so as to implement a certain color, image, pattern, feeling, and texture, etc. More specifically, as shown in (a) of FIG. 4, the cover portion 114 of a certain shape is positioned over the entire area of the first base member 112 at regular intervals, as shown in FIG. 4 (b), when viewed from a certain distance, the first base member 112 or the cover area CA in which the cover portion 114 is positioned may be recognized as one color as a whole.

More specifically, when the plurality of cover portions 114 are spaced apart from each other while having a certain distance and formed over a certain area ratio, when viewed from a certain distance, the plurality of cover portions 114 with a light transmitting area LTA therebetween may be recognized as one. That is, while the cover area CA in which the plurality of cover portions 114 are positioned is recognized as one color by the plurality of cover portions 114, the sunlight may pass through the first cover member 110 and be transmitted to the solar cell 150 without significant loss through the light transmitting area LTA composed of the first base member 112 with high light transmittance positioned between the plurality of cover portions 114.

In the above-described structure, it is exemplified that the cover portion 114 is formed only on a part of the first or second cover members 110 and 120. The size of the cover portion 114, the ratio of the total area of the cover portion 114 to the total area of the cover area CA, the spacing of the cover portion 114, etc. have various values that can be recognized as one color when the cover portion 114 is viewed from a certain distance (for example, 1 m). The cover portion 114 constituting the cover area CA may have various shapes including a circle, an ellipse, a polygon (triangle, a square, etc.), a stripe shape, a checkered shape, an irregular shape, or a combination thereof.

In the present embodiment, when the solar cell panel 100 is viewed with the naked eye from a certain distance or more (for example, more than 1m), due to the first cover member 110, the solar cell panel 100 may have a uniform color, image, pattern, feeling, texture, and the like as a whole. For example, when the solar cell panel 100 is viewed from a distance sufficient to view the exterior of the building (reference numeral 1 in FIG. 1, hereinafter the same), it is possible to improve the exterior of the building 1 while not significantly reducing the output.

However, the present disclosure is not limited thereto, and the cover portion 114 may be formed while having one color over the entire area of the first cover member 110. And the cover portion 114 may include a portion having two or more colors. In addition, various modifications are possible.

In the present embodiment, the second cover member 120 may include the cover part 124 to be formed of a colored glass substrate. In the present embodiment, the cover part 124 may be a part displaying a certain color so that the solar cell 150 and the wiring portions 142 and 145 are not recognized from the outside. Unlike the cover portion 114, the cover part 124 may have a specific color because it is positioned on the rear surface of the solar cell panel 100 having a building-integrated structure and diffusion and scattering of light are not required.

The second cover member 120 or the cover part 124 may have a color such that a color difference (ΔE^{∗}ab) level between the solar cell 150 (in particular, the anti-reflection layer 152 of the solar cell 150) and the second cover member 120 is 11 or less in the International Commission on Illumination (CIE) Lab (i.e. CIE L^{∗}a^{∗}b^{∗}) color coordinates, the D65 standard light source (noon solar light source). When the above-described color difference (ΔE^{∗}ab) level is 11 or less, the solar cell 150, the wiring portions 142 and 145, etc. may not be prevented from being recognized from the outside beyond a certain distance. Here, in the International Commission on Illumination (CIE) Lab (i.e. CIE L^{∗}a^{∗}b^{∗}) color coordinates, the D65 standard light source, the luminance L^{∗} may be 50 or less to have a relatively dark color. Then, the solar cell 150 and the wiring portions 142 and 145 may be effectively prevented from being recognized from the outside. However, the present disclosure is not limited thereto, and in the International Commission on Illumination (CIE) Lab (i.e. CIE L^{∗}a^{∗}b^{∗}) color coordinates, the D65 standard light source, the luminance L^{∗} may exceed 50 to have a relatively bright color.

At this time, the color of the cover part 124 may be the same as or different from the color of the cover portion 114. In particular, the cover part 124 may not be transparent, translucent, or the like, and may have an achromatic color except for white, an opaque color, or a color of the same series as that of the solar cell 150. For example, the cover part 124 may have black, gray, blue, green, brown, a color of the same series as that of the solar cell 150 (in particular, the anti-reflection layer 152 of the solar cell 150), or a color mixture thereof. Since white is a color with high brightness, it may be difficult to form the cover part 124 using the white color. For example, when the cover portion 124 is formed in the same color as the solar cell 150, the solar cell panel 100 has color uniformity as a whole, so that aesthetics may be further improved. However, the present disclosure is not limited thereto. Even if it is a color other than the above-mentioned color, various colors may be used as long as the color has a lower brightness than that of the cover part 114 or a lower light transmittance than that of the base member 112 and/or the base part 122.

As described above, if the second cover member 120 has a certain color and prevents the solar cell 150 from being recognized, it is not necessary to change the color of the sealing material 130. If a dye (e.g. carbon black) for changing a color is included in the sealing material 130, problems such as undesirably lowering of insulating properties of the sealing material 130 may occur. However, the present disclosure is not limited thereto, and various modifications are possible, such as having a dye or the like on at least a part of the sealing material 130.

For example, in the present embodiment, the cover part 124 may be made of an oxide ceramic composition. Then, the first and second cover members 110 and 120 may be formed by the same or similar manufacturing process, thereby simplifying the manufacturing process. In this case, for the oxide ceramic composition constituting the cover part 124 and the second cover member 120, the description of the oxide ceramic composition constituting the cover portion 114 and the first cover member 110 described above may be applied as it is.

However, the present disclosure is not limited thereto, and the cover part 124 may be formed of a material other than the oxide ceramic composition. For example, the second cover member 120 may include the second base member 122 and the cover part 124 that is formed on the second base member 122 and includes a plurality of cover layers. The plurality of cover layers may be formed in a number capable of implementing a specific color, and each cover layer may be made of a variety of materials, such as a dielectric material, an insulating material, a semiconductor material, and the like.

For example, in the present embodiment, the cover part 124 may implement the same or similar color to the anti-reflection layer 152 of the solar cell 150. For example, the cover part 124 may include a silicon layer including silicon constituting the photoelectric conversion unit of the solar cell 150, and a dielectric layer or insulating layer positioned on the silicon layer and having the same material and stacked structure as the antireflection layer 152. Then, the cover part 124 may have the same or similar color as the solar cell 150, thereby implementing the same or similar color as the solar cell 150. Accordingly, it is possible to effectively prevent the solar cell 150 and the wiring portions 142 and 145 from being recognized by the simple structure.

As another example, the cover part 124 may include a plurality of cover layers formed of each metal compound (e.g. metal oxide or metal nitride oxide). For example, the plurality of cover layers may have a structure in which a plurality of insulating layers formed of an oxide or nitride oxide including silicon, titanium, aluminum, zirconium, zinc, antimony, and copper are stacked. And when the plurality of cover layers are made of oxide or nitride oxide, the cover part 124 may further include a layer including silicon nitride and/or a layer including silicon carbon nitride inside or outside the plurality of cover layers, thereby preventing problems caused by ultraviolet rays, moisture, and the like.

For example, when the cover portion 124 includes a first cover layer composed of silicon oxide, a second cover layer disposed thereon and composed of silicon nitride, and a third cover layer disposed thereon and composed of silicon carbonitride, the cover part 124 may have a blue color. Alternatively, when the cover part 124 includes a first cover layer composed of zirconium oxide, a second cover layer disposed thereon and composed of silicon oxide, a third cover layer disposed thereon and composed of zirconium oxide, and a fourth cover layer disposed thereon and including silicon oxide, the cover part 124 may have a green color.

According to the present embodiment, the cover part 124 may be formed by a simple manufacturing process such as deposition, so that the second cover member 120 having a desired color may be manufactured. The cover part 124 may be positioned on an inner surface and/or an outer surface of the second cover member 120.

For example, the cover part 124 may be formed entirely to correspond to the effective area AA and the non-effective area NA, and may be formed only in a portion corresponding to the non-effective area NA and may not be formed in the effective area AA. If the cover part 124 is not formed in the effective area AA, the cost for forming the cover part 124 may be reduced.

In the above description, it is exemplified that the second cover member 120 includes the second base member 122 made of a glass substrate and the cover part 124, however, the present disclosure is not limited thereto. For example, the cover part 124 may be formed of a metal film (e.g. silver (Ag) or aluminum coated to have a black color) and deposited on the second base member 122 formed of a glass substrate. Alternatively, the second cover member 120 may be configured as one integrated member without the second base member 122 and the cover part 124. For example, the second cover member 120 may be formed of a metal plate (e.g. a steel plate), a circuit board, or the like. In addition, the second cover member 120 or the second base member 122 may be made of a sheet including a resin (for example, polycarbonate (PC), polyethylene terephthalate (PET), ethylene tetra fluoro ethylene (ETFE), polytetrafluoroethylene (PTFE), etc.), fiber reinforced plastic, etc. A separate cover part 124 may be formed on the second base member 122 made of such a sheet, or a pigment or the like may be included in the second base member 122 to have a certain color. The second base member 122 made of such a sheet may be formed of a single layer or a plurality of layers.

And in the above description, it is exemplified that the second cover member 120 is composed of a colored member having a certain color. However, the present disclosure is not limited thereto, and the second cover member 120 may have various characteristics such as light-transmitting properties, non-ight-transmitting properties, or reflective characteristics. Various other variations are possible.

FIG. 3 illustrates that the cover portion 114 is positioned on the outer surface of the first cover member 110 and the cover part 124 is positioned on the outer surface of the second cover member 120. The cover portion 114 is positioned on the outer surface side of the first cover member 110 so that glare that may occur when the solar cell panel 100 is applied to the building 1 may be prevented or minimized by the cover portion 114. In addition, it is possible to prevent a problem that may occur when sodium or potassium, etc., which undesirably remains in the cover portion 114 is directed to the inside of the solar cell panel 100. The cover part 124 may be positioned on the outer surface side of the second cover member 120 to be positioned close to the rear surface side of the solar cell panel 100. However, the present disclosure is not limited thereto. Accordingly, the cover portion 114 may be positioned on at least one of the inner surface and the outer surface of the first cover member 112, and/or the cover part 124 may be positioned on at least one of the inner surface and the outer surface of the second cover member 120. In addition, as described above, the light diffusion portion LD having irregularities, texturing, etc. formed on the other surface on which the cover part 114 or the cover part 124 is not formed may be formed. Various other modifications are possible.

Even when the cover portion 114 and/or the cover part 124 is formed, according to the shape, color, etc. of cover portion 114, the shape, etc. of the cover part 124, the wiring portions 142 and 145 (e.g. bus ribbon 145) including the wide portion having a width of 1 mm or more may be partially recognized. This phenomenon may occur not only when the cover portion 114 is partially formed but also when the cover portion 114 is formed as a whole. Accordingly, in the present embodiment, the coloring member 160 may be provided.

The coloring member 160 may have a specific color (for example, black, gray, or the same or similar color to the solar cell 150), and may have a different reflectivity from that of the wiring portions 142 and 145 (in particular, the bus ribbon 145) to prevent the wiring portions 142 and 145 from being recognized. Considering that the wide portions of the wiring portions 142 and 145 have a relatively large width and are made of metal and may be more easily recognized by reflection or the like, recognition of the wiring portions 142 and 145 may be more effectively prevented by covering the wide portions of the wiring portions 142 and 145 with the coloring member 160.

Here, a difference in saturation between the coloring member 160 and the solar cell 150 may be 10 or less. In addition, a difference in saturation between the coloring member 160 and the rear surface portion positioned on the rear surface of the solar cell portion SP (i.e. the second sealing material 132 and the second cover member 120) may be 10 or less. For example, a difference in saturation between the coloring member 160, the solar cell 150 and the rear surface (e.g. the second cover member 120) may be 10 or less. When the coloring member 160 has the above-described saturation, recognition of the wide portions of the wiring members 142 and 145 may be effectively prevented.

The coloring member 160 may be configured in the form of a film, a sheet form, or a tape form having a thickness of 1 mm or less, and may be positioned at a desired position in various ways. For example, the coloring member 160 may be positioned by cohesion or adhesion to the solar cell portion SP (particularly, the bus ribbon 145). Alternatively, the coloring member 160 may be fixed to the solar cell portion SP by the sealing material 130 in a lamination process in a state in which it is placed on the solar cell portion SP (e.g. the bus ribbon 145). Here, the cohesion may mean an adhesive force to the extent that two layers can be attached to or separated from each other by physical force at room temperature, and the adhesion may mean that when two layers are attached to each other through heat treatment and the two layers are separated, either layer is damaged. When the coloring member 160 is fixed to the solar cell portion SP by cohesion, during the manufacturing process cohesion, separation, and position adjustment, etc. of the colored member 160 are easy. When the coloring member 160 is fixed to the solar cell portion SP by adhesion, the coloring member 160 may be more stably fixed during the lamination process. When the coloring member 160 is placed on the solar cell portion SP without using a separate adhesive or cohesive material, the process may be simplified. The size, shape, arrangement, etc. of the coloring member 160 may be variously modified.

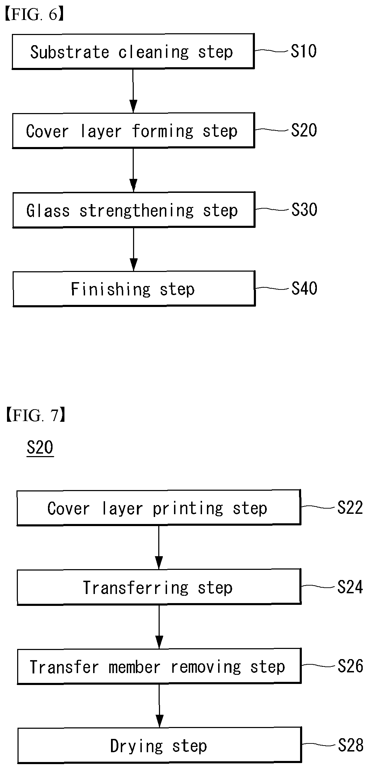

Hereinafter, as described above with reference to FIGS. 6, 7, and 8A to 8E together with FIGS. 1 to 4, a method of forming the cover portion 114 made of the oxide ceramic composition having an amorphous state glass structure on the first base member 112 (that is, the method of manufacturing the first cover member 110 having the cover portion 114 according to the present embodiment or the method of manufacturing the graphic cover substrate according to the present embodiment), and the cover portion 114 manufactured thereby will be described in detail. In the following description, a method of manufacturing the first cover member 110 having the cover portion 114 has been described as an example, however, the present disclosure is not limited thereto. That is, the following description may be applied to a method of manufacturing the second cover member 120 including the cover part 124. Various other variations are possible.

FIG. 6 is a flowchart illustrating an example of a method of manufacturing a first cover member 110 according to an embodiment of the present disclosure, and FIG. 7 is a flowchart illustrating an example of a cover layer forming step S20 included in a method of manufacturing a first cover member 110 shown in FIG. 6. FIGS. 8A to 8E are cross-sectional views illustrating each step of a manufacturing method of a first cover member 110 illustrated in FIG. 6.

Referring to FIG. 6, the method of manufacturing the first cover member 110 according to the present embodiment may include a substrate cleaning step S10, a cover layer forming step S20, a glass strengthening step S30, and a finishing step S40. Referring to FIG. 7, in the present embodiment, the cover layer forming step S20 may include a cover layer printing step S22, a transferring step S24, and a drying step S28, and may further include a transfer member removing step S26.

First, in the substrate cleaning step S10, a first base member 112 composed of a non-strengthened glass substrate is cleaned and dried. Foreign substances or an oil film and the like of the first base member 112 may be removed by the substrate cleaning step S10.

In this case, the non-strengthened glass substrate may have a light transmittance of 80% or more (for example, 85% or more) for light having a wavelength of 380 nm to 1200 nm, and a thickness of 2.8 mm or more. For example, the non-strengthened glass substrate may be a non-strengthened glass substrate for construction, and may be prepared by cutting, chamfering, or surface etching.

Subsequently, as shown in FIGS. 8A to 8D, in the cover layer forming step S20, a cover layer 1140 is formed on the first base member 112. At this time, in the present embodiment, the cover layer 1140 is not directly printed and applied on the first base member 112 in the cover layer forming step S20, and after the cover layer 1140 is formed on a transfer member 1120, the cover layer 1140 is formed on the first base member 112 by transferring it to the first base member 112.

As shown in FIG. 8A, in the cover layer printing step S22, the cover layer 1140 is formed on the transfer member 1120 by a printing process. Although the description has been focused on printing the cover layer 1140, since various processes in which the cover layer 114 may be applied on the transfer member 1120 may be used, the cover layer printing step S22 may be regarded as a cover layer application step.

The cover layer 1140 may be composed of a ceramic material layer (ceramic ink, ceramic paste, or ceramic solution, etc.) including a ceramic frit 1144, a dye 1142, and a resin 1146. In addition, the ceramic material layer may further include an additive or the like, if necessary. The additive may include various materials such as oxides and metals in consideration of desired characteristics. Alternatively, wax, water, oil, an organic solvent, or a diluent for adjusting the viscosity may be further included as an additive. However, the present disclosure is not limited thereto, and may not include an additive to maintain small particles for passing through a mesh used for forming the ceramic material layer and a nozzle for applying the ceramic material layer.

Here, the ceramic frit 1144 may basically serve to stably couple the cover portion 114 to the first base member 112 (in particular, a glass substrate), and may optionally serve to implement a specific color, texture, feeling, and the like.

The ceramic frit 1144 may be a compound including a plurality of metals and a non-metal, and may be formed by including a plurality of metal compounds. The ceramic frit 1144 may be formed of an oxygen polyhedron having a random network structure including a plurality of metals and oxygen or a glass structure. When the plurality of metal compounds are each composed of a metal oxide, the random network structure or the glass structure may be easily and stably formed. In the present disclosure, that it may be formed including a plurality of metal compounds (e.g. metal oxide) means that the ceramic frit 1144 is manufactured using a plurality of metal compounds (e.g. metal oxide) so that the ceramic frit 1144 is formed by including at least a part of a compound structure including the plurality of metals and a non-metal (e.g. oxygen), the random network structure, the glass structure, and the like.

The ceramic frit 1144 may include a variety of known materials. For example, the ceramic frit 1144 may be formed by including at least one of aluminum oxide (AlOx, e.g. Al₂O₃), sodium oxide (NaOx, e.g. Na₂O), bismuth oxide (BiOx, e.g. Bi₂O₃), boron oxide (BOx, e.g. B₂O), and zinc oxide (ZnOx, e.g. ZnO) together with silicon oxide (SiOx, e.g. SiO₂) as a basic material. Other ceramic frits 1144 may be formed by further including aluminum oxide, sodium oxide, bismuth oxide, boron oxide, zinc oxide, titanium oxide (TiOx, e.g. TiO₂), zirconium oxide (ZrOx, e.g. ZrO₂), potassium oxide (KOx, e.g. K₂O), lithium oxide (LiOx, e.g. Li₂O), calcium oxide (CaOx, e.g. CaO), cobalt oxide (CoOx), iron oxide (FeOx), etc. For example, the ceramic frit 1144 may be formed of a bismuth boro-silicate based ceramic material (for example, Bi₂O₃-Al₂O-SiO₂ based materials) formed including bismuth oxide, boron oxide, and silicon oxide. Alternatively, the ceramic frit 1144 may be formed of a NAOS-based ceramic material (e.g. a Na₂O-Al₂O₃-SiO₂ based material) including sodium oxide, aluminum oxide, and silicon oxide. Alternatively, the ceramic frit 1144 may be formed of a ceramic material (e.g. a ZnO-SiO₂-B₂O₃-based material) including zinc oxide, silicon oxide, and boron oxide. However, the present disclosure is not limited thereto, and the ceramic frit 1144 may be formed of various other materials.

The dye 1142 is included to make the cover portion 114 have a desired appearance. For example, when the cover portion 114 has a certain color, as the dye 1142, a material capable of selectively absorbing or reflecting visible light in sunlight to exhibit a unique color may be used. For example, the dye 1142 may be a pigment. The pigment is a dye composed of an inorganic component that is not dissolved in water and most organic solvents, and coats the surface of the first base member 112 to exhibit a color. The pigment has excellent chemical resistance, light resistance, weather resistance and hiding power. That is, the pigment may be resistant to bases and acids, may be difficult to discolor or fade when exposed to ultraviolet light, and may be weather-resistant. For reference, if a dyestuff composed of an organic component soluble in an organic solvent is used as a dye, the molecular structure may be easily broken by sunlight, and thus stability may be reduced, and the manufacturing process may be complicated by forming a protective layer or the like for protecting the same. Accordingly, in the present embodiment, the dye 1142 may not include a dye. However, the present disclosure is not limited thereto, and the dye 1142 may include various materials such as dyes.

The dye 1142 may be made of a material that considers the appearance of the desired cover portion 114. Although the drawing shows that the dye 1142 is provided separately from the ceramic frit 1144, the present disclosure is not limited thereto. For example, the desired appearance of the cover portion 114 may be implemented by the material constituting the ceramic frit 1144, so that the dye 1142 may not be provided separately from the ceramic frit 1144. Alternatively, the distinction between the ceramic frit 1144 and the dye 1142 may not be clear. In the present embodiment, the metal of the material included as the dye 1142 may be included by partially substituting the metal of the random network structure or the glass structure (e.g. oxygen polyhedron) constituting the ceramic frit 1144. Alternatively, the metal included in the dye 1142 may be positioned in the random network structure of the ceramic frit 1144, the glass structure, or the interstitial site of the oxygen polyhedron.

For example, the cover portion 114 may have a white color due to a metal compound (e.g. metal oxide) included in the ceramic frit 1144. For example, when the ceramic frit 1144 is formed to include at least one of the group including lead oxide (PbOx, e.g. PbO), titanium oxide, aluminum oxide and bismuth oxide, the cover portion 114 may have a white color. In this case, when the cover portion 114 has a white color, it may further include a material such as boron oxide in addition to the above-described material. For example, when the cover portion 114 has a white color, the ceramic frit 1144 may be formed of a ceramic material (BiOx-SiOx-B₂O-based material) formed including bismuth oxide, silicon oxide and boron oxide, a ceramic material (PbOx-SiOx-B₂O-based material) formed including lead oxide, silicon oxide and boron oxide, a ceramic material (TiOx-SiOx-B₂O-based material) formed including titanium oxide, silicon oxide and boron oxide, and a ceramic material (AlOx-SiOx-B₂O-based material) formed including aluminum oxide, silicon oxide and boron oxide, and the like. However, lead oxide may not be included in the cover portion 114 or the ceramic frit 1144 according to the present embodiment considering environmental issues, etc.

As another example, various dyes 1142 may be included so that the cover portion 114 has a color other than white. That is, in consideration of a desired color, one or more materials corresponding thereto may be used as the dye 1142. The material constituting the dye 1142 may be in the form of a metal or an oxide, carbide, nitride, sulfide, chloride, silicate, or the like containing metal.

For example, a material including at least one of copper (Cu), iron (Fe), nickel (Ni), chromium (Cr), uranium (U), and vanadium (V) may be used as the dye 1142 to represent a series such as red, yellow, etc. A material including at least one of titanium (Ti), magnesium (Mg), and rutile may be used as the dye 1142 to represent a series of green or blue colors, etc. In addition, the dye 1142 may include cobalt oxide, iron oxide, copper oxide (CuOx), chromium oxide (CrOx), nickel oxide (NiOx), manganese oxide (MnOx), tin oxide (SnOx), antimony oxide (SbOx), vanadium oxide (VOx), or the like.

As a more specific example, as the dye 1142, CoAl₂O₄ may be used to implement cyan, Co₂SiO₄, etc. may be used to implement blue, CoCr₂O₄, etc. may be used to implement green, Ti(Cr, Sb)O₂ may be used to implement yellow, CoFe₂O₄, Co-Cr-Fe-Mn spinel, etc. may be used to implement black. Alternatively, as the dye 1142, NiO, Cr₂O₃, etc. may be used to implement green, Cr-AI spinel, Ca-Sn-Si-Cr spin, Zr-Si-Fe zircon, etc. may be used to implement pink, Sn-Sb-V rutile may be used to implement gray, Ti-Sb-Ni rutile, Zr-V badelite, etc. may be used to implement yellow, Co-Zn-AI spinel may be used to implement blue, Zn-Fe-Cr spinel may be used to implement brown, Ca-Cr-Si garnet or the like may be used to implement green, Co-Zn-Si willemite, Co-Si olivine, etc. may be used to implement dark blue, Zn-Fe-Cr-Al spinel or the like may be used to implement brown, and Au or the like may be used to implement magenta. These materials are merely presented as examples, and the present disclosure is not limited thereto.

The above description exemplifies that the cover portion 114 has a certain color. However, the present disclosure is not limited thereto. Therefore, the cover portion 114 may have a transparent or translucent color, may be for showing gloss or matte, may be for expressing a specific texture, or may be for preventing glare. In this case, the dye 1142 may be included in the cover portion 114, but the dye 1142 may not be included. In this case, the ceramic frit 1144 may not include lead oxide, aluminum oxide, or the like, which may exhibit white color so that the cover portion 114 does not have a white color. For example, when the cover portion 114 has a transparent or translucent color, the ceramic frit 1144 may be made of a ceramic material (NaOx-SiOx-B₂O-based material) formed including sodium oxide, silicon oxide, and boron oxide. Titanium oxide and bismuth oxide are materials that may be used to implement white color, but even if some of them are included, the cover portion 114 may remain transparent or translucent. However, even when the cover portion 114 has a transparent or translucent color, a small amount of a pigment or dye 1142 may be included for slight color development (e.g. translucent to red, transparent to green, etc.).

The resin 1146 may be a material used to uniformly mix the dye 1142 and the ceramic frit 1144 to have appropriate viscosity, fluidity, etc. when the ceramic material layer is applied, and may be volatile material that may be volatilized. The resin 1146 may include a variety of known materials. For example, as the resin 1146, an organic resin such as an acrylic resin or a cellulose resin may be used, or an inorganic resin such as a silicone resin may be included.

The ceramic material layer or cover layer 1140 may include the ceramic frit 1144 in the largest amount, and even when the dye 1142 is included, the dye 1142 may be included in a smaller amount than the ceramic frit 1144. For example, when the dye 1142 is included, based on 100 parts by weight of the ceramic material layer or cover layer 1140, the ceramic frit 1144 may be included in an amount of 40 to 90 parts by weight (e.g. 50 to 90 parts by weight), the dye 1142 may be included in an amount of 5 to 50 parts by weight, and the resin 1146 and/or additives may be included in an amount of 0 to 20 parts by weight. When the dye 1142 is not separately included, based on 100 parts by weight of the ceramic material layer or cover layer 1140, the ceramic frit 1144 may be included in an amount of 50 to 100 parts by weight (e.g. 60 to 100 parts by weight), and the resin 1146 and/or additives may be included in an amount of 0 to 50 parts by weight (e.g. 0 to 40 parts by weight). However, the present disclosure is not limited thereto, and the ceramic material layer or the cover layer 1140 may have various compositions.

In the present embodiment, as the printing process, inkjet printing (e.g. digital inkjet printing), screen printing, lithography printing, laser printing, etc. may be applied.

As an example, digital inkjet printing may be used in the present embodiment, and according to this, there is no limit to the number of printing processes, so the degree of design freedom is high and various colors may be used. For reference, the screen printing is possible up to 4 degree printing, so the degree of design freedom is relatively low and there is a limit to diversifying colors.

Here, the digital inkjet printing may include printing (a so-called digital inkjet printing for ceramics) using a ceramic material layer including relatively large particles (for example, particles having a central particle diameter of 50 µm or more) and printing (a so-called digital inkjet printing for glass) using a ceramic material layer including relatively small particles (for example, particles having a central particle diameter of less than 50 µm). In the so-called digital inkjet printing process for ceramics, the cost of the ceramic material layer is cheap and relatively inexpensive equipment is used, whereas in the so-called digital inkjet printing for glass, the materials constituting the ceramic material layer must be grinded evenly and uniformly, and a small-sixed nozzle is used, so the material cost is high and relatively expensive equipment is used.

Conventionally, in order to form the cover layer 1140 on the first base member 112 composed of a glass substrate, the above-described so-called digital inkjet printing for glass had to be used, and when the cover layer 1140 is formed on the transfer member 1120 as in the present embodiment, the so-called digital inkjet printing for ceramics can be used, thereby reducing material costs and using relatively inexpensive equipment. Thereby, productivity may be improved. However, the present disclosure is not limited thereto. Therefore, in order to form the cover layer 1140, the so-called digital inkjet printing for glass or various processes such as screen printing may be used.

When the cover layer 1140 is formed by the printing process as described above, the cover layer 1140 may be stably formed to have a desired thickness by a simple process. However, the present disclosure is not limited thereto, and the cover layer 1140 may be formed on the transfer member 1120 by various other methods. For example, the cover layer 1140 may be formed on the transfer member 1120 by a spray process, a sol-gel process, or the like.

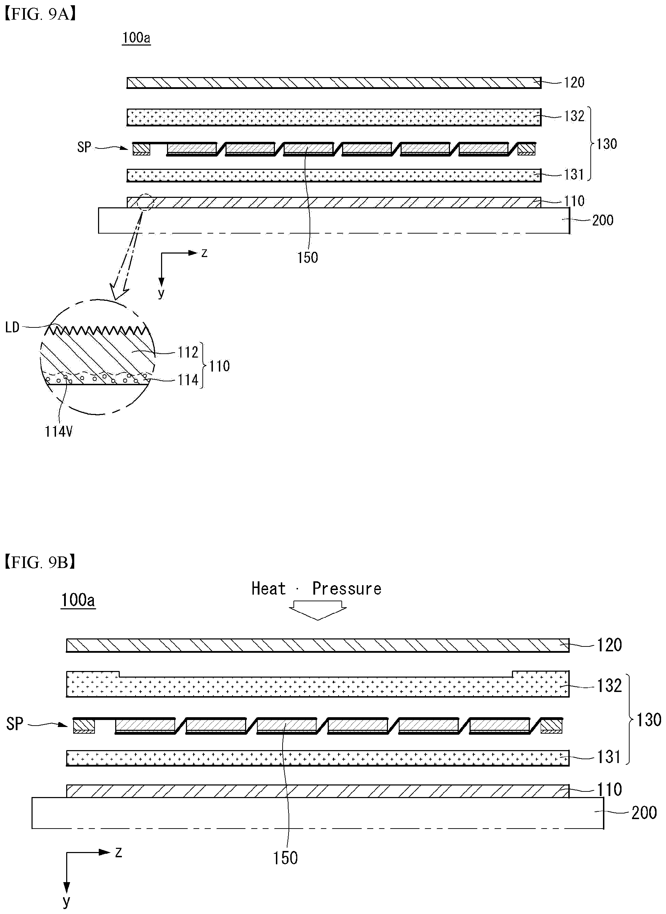

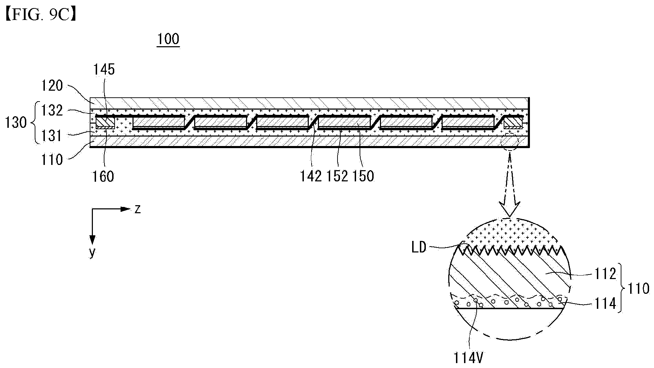

Subsequently, as shown in FIGS. 9B and 9C, in the transferring step S24 and the transfer member removing step S26, the cover layer 1140 formed on the transfer member 1120 is transferred to the first base member 112 and to separate or remove the transfer member 1120. For example, the cover layer 1140 may be transferred to the first base member 112 by thermal transfer applying heat.

In the present embodiment, as an example, it is exemplified that the transfer member 1120 includes a base portion 1120a and a release layer 1120b positioned thereon, and the cover layer 1140 is formed on the release layer 1120b. As the base portion 1120a, a sheet or film made of various materials (e.g. resin) capable of supporting the cover layer 1140 and having various thicknesses may be used. The release layer 1120b may include various materials having various materials and properties, and thus may be removed under specific materials, conditions, or the like, or may include various materials capable of separating the base layer 1120a. For example, the release layer 1120b may be a material that can be removed by a dissolving material such as water or oil.

With such a structure, a transfer process of applying heat may be performed while the transfer member 1120 is positioned on the first base member 112 so that the cover layer 1140 is in contact with the first base member 112, and the base portion 1120a may be removed or separated using the release layer 1120b before or after the transfer process. In the process of removing or separating the base portion 1120a, the base portion 1120a may be separated from the cover layer 1140 by removing the release layer 1120b using a specific material, or the release layer 1120b may remain by separating the base portion 1120a from the release layer 1120b. The remaining release layer 1120b may be removed or may remain partially by burning in the glass strengthening step S30, etc.

For example, an adhesive layer is further provided on the cover layer 1140 to separate the base layer 1120a using the release layer 1120b while the adhesive layer is attached to the first base member 112. In this state, the cover layer 1140 and the first base member 112 may be hot-pressed using a hot roller or the like to transfer the cover layer 1140 to the base layer 1120a. The adhesive layer may be removed in a hot pressing process or may remain inside the cover layer 1140. In addition, the transfer member 112 may include various layers such as a protective coating layer. Alternatively, the release layer 1120b may not be provided. In addition, the transfer member 112 may have various shapes, such as a film, a sheet, and a sticker. Various other methods may be applied.

As a modification, the transfer member 1120 formed with the cover layer 1140 is immersed in a dissolving material capable of removing the release layer 1120b, and in a state where the cover layer 1140 is placed in the dissolving material while maintaining its shape, it is also possible to transfer the first base member 112 in contact with the cover layer 114.

As another modification, thermal transfer may be performed while the transfer member 112 including the cover layer 1140 is positioned on the first base member 112. A process of separately removing or separating the release layer 1120b and/or the base portion 1120a is not performed before or after the thermal transfer process, so that the release layer 1120b and/or the base portion 1120a may remain after the transfer process. The remaining release layer 1120b and/or the base portion 1120a may be removed or partially left by burning in the glass strengthening step S30, etc.

As another modification, in a state in which the transfer member 112 having the cover layer 1140 is positioned on the first base member 112, the glass strengthening step S30 is performed without a separate transfer process so that thermal transfer may be performed in the glass strengthening step S30. In this case, the transfer member 112 may be removed or may remain partially by burning in the glass strengthening step S30.

Subsequently, as shown in FIG. 8D, in the drying step S28, the resin 1146 is volatilized while drying the cover layer 1140 by applying heat. The resin 1146, etc. is first volatilized so that the dye 1142 and the ceramic frit 1144 may be effectively mixed together with the first base member 112. In the drying step S28, the resin 1146 or the additive may be all removed, or some may remain. In this case, air bubbles (pores) (reference numeral 114V in FIG. 8E, hereinafter the same) composed of empty spaces may remain in at least a part of the part from which the resin 1146 or the additive has been removed. However, the cover layer 114 may not include the air bubble 114V. For example, in the drying step S28, the cover layer 1140 may be dried at a temperature of 50 to 200°C. The drying step S28 may be performed using an infrared heating device, ultraviolet curing, or the like. However, the present disclosure is not limited thereto, and the drying temperature and drying method may be variously changed. In addition, the drying step S28 may not be separately provided or may be performed together by another heat treatment process.

Subsequently, as shown in FIG. 8E, in the glass strengthening step S30, the non- strengthened glass substrate constituting the first base member 112 is strengthened or semi- strengthened by thermal strengthening by heat treatment or annealing. At that time, the ceramic frit 1144, the dye 1142, etc. included in the cover layer 1140 are incorporated into the strengthened or semi-strengthened glass substrate in order to achieve phase equilibrium, and the cover portion 114 constituting a part of the strengthened or semi-strengthened glass substrate is formed. Here, the cover layer 1140 may have a greater specific gravity than the first base member 112 due to a high mass ratio, then, the cover layer 1140 may be more easily incorporated into the interior of the first base member 112 composed of the glass substrate while the cover layer 1140 is fused and sticky due to the high temperature in the glass strengthening step S30.

In the glass strengthening step S30, it may be performed at a temperature at which the non-strengthened glass substrate may be strengthened or semi-strengthened. For example, the heat treatment temperature of the glass strengthening step S30 may be 500 to 800 °C (for example, 500 to 750 °C, for example, 640 to 720 °C), and it may be heat-treated in a state that is not highpressure treatment (for example, at atmospheric pressure or a pressure lower than atmospheric pressure). For example, in the case of strengthening, it may be heat treated at a pressure of 5 to 20 kPa, and in the case of semi- strengthening, it may be heat treated at a pressure of 4 kPa. In this case, the heat treatment time may be adjusted according to the pressure, when the pressure is high, the heat treatment time may be relatively short, and when the pressure is low, the heat treatment time may be relatively long. However, the present disclosure is not limited to the temperature, pressure, time, etc. of the glass strengthening step S30.

For example, in the glass strengthening step S30, the non-strengthened glass substrate constituting the first base member 112 may be semi-strengthened. Accordingly, the first base member 112 or the first cover member 110 may be formed of a semi-strengthened glass substrate that is heat-strengthened. Accordingly, the transmittance of the first cover member 110 may be maintained high. Here, the first cover member 110 made of semi-strengthened glass may have a surface compressive stress of 60 MPa or less (e.g. 24 to 52 Mpa). For example, the edge stress of the first cover member 110 may be about 30 to 40 MPa. That is, this semi-strengthened glass may be formed by annealing after heat treatment at a temperature somewhat lower than the softening point. For reference, the fully-strengthened glass may be formed by quenching after heat treatment at a temperature higher than the softening point, and the surface compressive stress is 70 to 200 MPa.

As described above, in the present embodiment, the light transmittance of the cover portion 114 may be maintained high by adjusting the heat treatment temperature, the cooling rate, etc. in the glass strengthening step S30. In particular, the average light transmittance for light in the infrared region may be maintained relatively high by maintaining the heat treatment temperature within a certain range while lowering the cooling rate to a certain level or less so that the cover portion 114 has an amorphous glass structure. On the other hand, when the heat treatment temperature is not maintained within a certain range and/or the cooling rate or pressure is too large, it may be difficult for the average light transmittance of the infrared region to have a higher level than the average light transmittance of the visible light region due to a phase change in the amorphous glass structure or a change in the interfacial bond between glass substrates due to a change in the chemical structure of the oxide ceramic composition that is the cover portion. And when the heat treatment temperature is less than a certain level (for example, less than 640 °C), the possibility that the cover portion 114 may be peeled from the base member 112 may increase, and when the heat treatment temperature exceeds a certain level (for example, greater than 720°C), it may be difficult for the cover portion 114 to have desired characteristics, such as the cover portion 114 does not have a desired color or the transmittance tendency is changed.

Subsequently, in the finishing step S40, the first cover member 110 on which the glass strengthening step S30 has been performed is cleaned and dried. Then, the manufacturing of the first cover member 110 having the integrated cover portion 114 is completed.

In this case, the content of sodium or potassium in the ceramic material layer, the cover layer 1140, or the cover portion 114 may be similar to or lower than that of the first base member 112. In particular, the content of sodium and potassium in the ceramic material layer, the cover layer 1140, or the cover portion 114 may be lower than the content of sodium and potassium of the first base member 112, respectively. For example, the ceramic material layer, the cover layer 1140, or the cover portion 114 may each contain sodium and potassium in an amount of 10 X 1018 pieces/cc or less. On the contrary, when the ceramic material layer, the cover layer 1140, or the cover portion 114 contains sodium or potassium in excess of the above-described range, a potential-induced degradation (PID) phenomenon may occur due to leakage current, thereby reducing the reliability of the solar cell panel 100. In addition, since the ceramic material layer, the cover layer 1140, or the cover portion 114 does not contain lead and/or chromium (e.g. lead oxide and/or chromium oxide), environmental problems may not occur. For example, the amounts of sodium, potassium, and lead included in the ceramic material layer, the cover layer 1140, or the cover portion 114 may be measured or determined by secondary ion mass spectrometry (SIMS).

Hereinafter, a method of manufacturing the solar cell panel 100 according to an embodiment of the present disclosure including the method of manufacturing the graphic cover substrate or the first cover member 110 described above will be described in detail with reference to FIGS. 9A to 9C.

FIGS. 9A to 9C are diagrams schematically illustrating a method of manufacturing a solar cell panel 100 according to an embodiment of the present disclosure.

First, as shown in FIG. 9A, in the lamination process, a stacked structure 100a, in which the first cover member 110 which is a graphic cover substrate having the cover portion 114, the first sealing material 131, the solar cell portion SP, the first sealing material 132, the second cover member 120, etc. are stacked, is positioned on the work table 200 of the lamination apparatus. In FIGS. 9A and 9B, the first cover member 110, the first sealing material 131, the solar cell portion SP, the first sealing material 132, the second cover member 120, etc. are shown to be spaced apart from each other for clear understanding, but in reality, they may be positioned in contact with each other.

Subsequently, as shown in FIG. 9B, in the lamination process, heat and pressure are applied to the stacked structure 100a to integrate the first cover member 110, the first sealing material 131, the solar cell portion SP, the first sealing material 132, the second cover member 120, etc. That is, the sealing material 130 may be melted and cured at a high temperature in the lamination process, and the solar cell portion SP may be sealed while the sealing material 130 completely fills a space between the first cover member 110 and the second cover member 120 compressed by pressure. Accordingly, the space between the first cover member 110 and the second cover member 120 may be completely filled by the sealing material 130. Accordingly, the solar cell panel 100 as shown in FIG. 9C is manufactured. For example, the first cover member 110, the first sealing material 131, the solar cell portion SP, the first sealing material 132, the second cover member 120, and the like may be integrated by providing air pressure. Accordingly, the lamination process may be performed without applying a large pressure to the solar cell 150 or the like.

According to this, the solar cell panel 100 including the first cover member 110, which is the graphic cover substrate, may be formed through a simple and stable manufacturing process.

According to the first cover member 110 and the solar cell panel 100 including the same according to the present embodiment, the cover portion 114 is provided to have excellent aesthetic uniformity and prevent glare. At this time, by using the transferring process to form the cover portion 114 uniformly and stably by a simple manufacturing process that does not change the manufacturing process of the solar cell panel 100, the solar cell panel 100 may have a desired design. In addition, when the cover layer 1140 is printed on the transfer member 1120, the thickness, transmittance, print density, printing area, etc. of the cover layer 1140 are adjusted to maintain the output above a certain level while improving the aesthetics of the solar cell panel 100.

Hereinafter, a solar cell panel and a method of manufacturing the same according to another embodiment of the present disclosure will be described in detail. A detailed description of the same or extremely similar parts to the above description will be omitted and only different parts will be described in detail. In addition, combinations of the above-described embodiment or a modified example thereof and the following embodiment or modified examples thereof are also within the scope of the present disclosure.

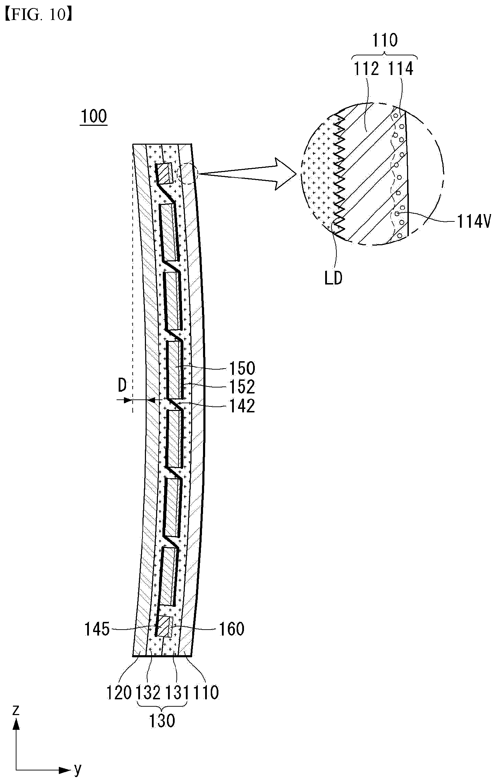

FIG. 10 is a schematic cross-sectional view of a solar cell panel according to another embodiment of the present disclosure.

Referring to FIG. 10, a solar cell panel 100 according to the present embodiment may include a portion having a curved surface. For example, a first cover member 110 and/or a second cover member 120 may include a portion having a curved surface. Although FIG. 10 illustrates that the solar cell panel 100 including the first and second cover members 110 and 120 has a convex or concave curved shape as a whole, the present disclosure is not limited thereto.

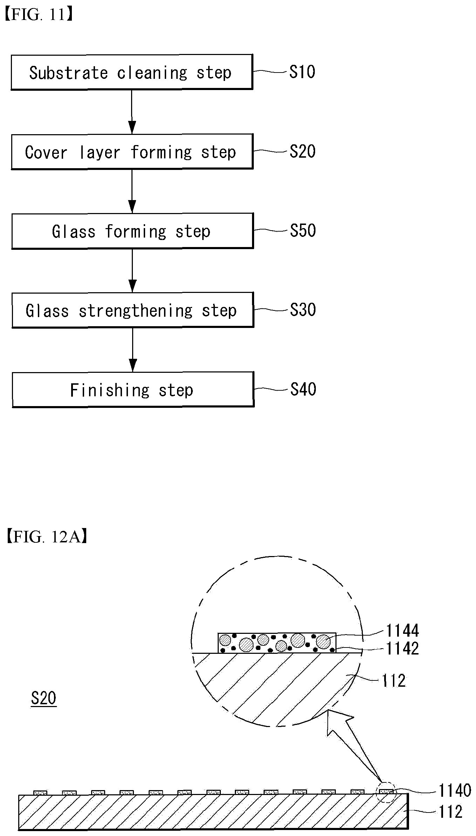

An example of a method of manufacturing the first cover member 110 included in the solar cell panel 100 will be described with reference to FIG. 11 and FIGS. 12A to 12C. FIG. 11 is a flowchart illustrating an example of a method of manufacturing a first cover member according to another embodiment of the present disclosure, and FIGS. 12A to 12C are cross-sectional views illustrating each step of the method of manufacturing the first cover member illustrated in FIG. 11.

Referring to FIG. 11, the method of manufacturing the first cover member 110 according to the present embodiment may includes a substrate cleaning step S10, a cover layer forming step S20, a glass forming step S50, a glass strengthening step S30, and a finishing step S40. Here, the substrate cleaning step S10, the cover layer forming step S20, the glass strengthening step S30, and the finishing step S40 may be the same as or extremely similar to the substrate cleaning step S10, the cover layer forming step S20, the glass strengthening step S30, and the finishing step S40 in the above-described embodiment, so a description thereof will be omitted. The present embodiment is different from the above-described embodiment in that it includes the glass forming step S50 before the glass strengthening step S30.

As shown in FIG. 12A, the cover layer 114 is formed on the first base member 112 by transferring the cover layer 1140 from the transfer member (reference numeral 1120 in FIG. 8A, hereinafter the same) to the first base member 112 using a transfer process by the cover layer forming step S20.

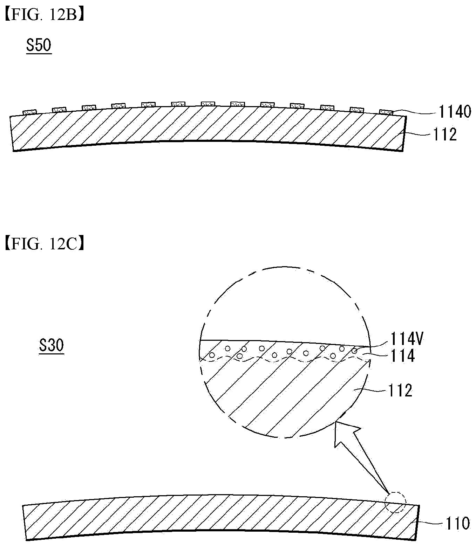

Next, as shown in FIG. 12B, in the glass forming step S50, the first base member 112 on which the cover layer 114 is formed is shaped to have a desired shape. This glass forming step S50 may be performed in a strengthening furnace and may occur by heat treatment performed at a lower temperature (e.g. 580 to 650°C) than the glass strengthening step S30. For example, the first base member 112 may be softened by heat treatment to form the first base member 112 into a desired shape.

Subsequently, as shown in FIG. 12C, the cover portion 114 is formed while strengthening or semi-strengthening the non-strengthened glass substrate constituting the first base member 112 by thermal strengthening by heat treatment or annealing by the glass strengthening step S30. The glass strengthening step S30 may be performed by an in-situ process that is continuously performed in the same strengthening furnace as the glass forming step S50, or may be performed in a separate strengthening furnace different from the strengthening furnace in which the glass forming step S50 is performed.

The solar cell panel 100 having a curved shape may be manufactured by performing a lamination process including the first base member 112 manufactured in this way.

According to the present embodiment, the first cover member 110 having various desired shapes and having the cover portion 114 may be manufactured by a simple process. Accordingly, it is possible to improve the design freedom and the aesthetics of the first cover member 110 and the solar cell panel 100 including the same.

At this time, if the first cover member 110 is formed including the transferring step S24 as in the present embodiment, the cover portion 114 may be formed in a more uniform and stable process than forming the cover layer 1140 by direct printing on the first cover member 110 having a curved surface, etc. In particular, when the height difference (D) between the highest point and the lowest point due to the curved surface is 5 µm or more, when the cover layer 1140 is formed on the first cover member 110 by direct printing, it may be difficult to stably form the cover layer 1140 or the cover portion 114, but according to the present embodiment, the cover portion 114 may be stably formed on the first cover member 110 having the height difference D of 5 µm or more. For example, the first cover member 110 having an artificially curved surface, etc. may have a very large value in which the height difference D is 50 mm or more, but in the present embodiment, even if applied when the height difference D is 50 mm or more as described above, the cover layer 1140 or the cover portion 114 may be stably formed. However, the present disclosure is not limited thereto, and the present embodiment may be applied when the height difference D is less than 5 µm (for example, less than 50 mm) or there is no height difference D.

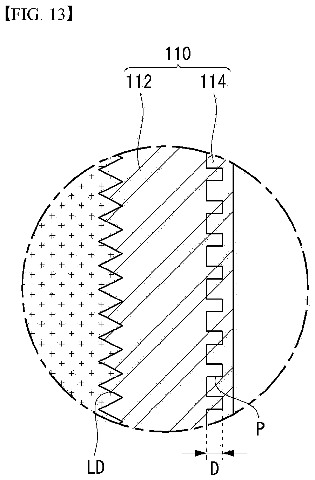

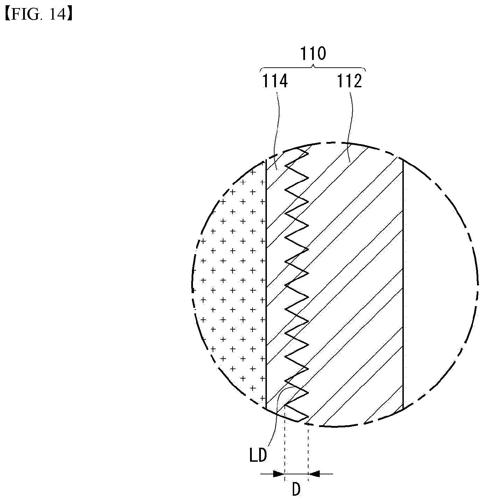

FIGS. 10, 11, and 12A to 12C illustrate that the first cover member 110 or the solar cell panel 100 has a curved surface. However, the present disclosure is not limited thereto. Another example will be described with reference to FIGS. 13 and 14. FIGS. 13 and 14 illustrate a part of the first cover member 110 and the first base member 112 and the cover portion 114 only in a schematic form for simple illustration and clear understanding.

As another example, when a protrusion (irregularities) P having a certain height difference D is provided on one surface of the first base member 112, the method of manufacturing the first cover member 110 according to the present embodiment, as shown in FIG. 13, may be applied to form the cover layer (reference numeral 1140 in FIG. 8A, hereinafter the same) or the cover portion 114. Even in this case, the cover layer 1140 or the cover portion 114 may be stably formed regardless of the shape of the protrusion P, the height difference D, and the like.

As another example, when the light diffusion portion LD formed to have a certain height difference D is provided on one surface of the first base member 112, the method of manufacturing the first cover member 110 according to the present embodiment, as shown in FIG. 14, may be applied to form the cover layer 1140 or the cover portion 114 on the light diffusion portion LD. Even in this case, the cover layer 1140 or the cover portion 114 may be stably formed regardless of the shape of the light diffusion portion LD, the height difference D, and the like.

FIGS. 10, 13, and 14 illustrate the curved surface, the protrusion P, and the light diffusion portion LD, but the cover portion 114 may be stably formed on the first base member 112 having various curves, irregularities, and the like having a circular shape, a round shape, and a polygonal shape in the cross-sections. For example, the first base member 112 may have a constant surface roughness even without a separate treatment, and the height difference D due to the surface roughness may be 5 µm or more (e.g. 30 µm or more). Alternatively, when a curved surface, etc. is formed on the first base member 112 through separate processing, etc., the height difference by this may be 50 mm or more. In particular, when the height difference D is 5um or more (for example, 50 mm or more), and the cover layer 1140 or the cover portion 114 is formed directly on the first base member 112, the thickness of the cover layer 1140 or the cover portion 114 is undesirably thickened, so that the transmittance is lowered to lower the efficiency, or the cover layer 1140 or the cover portion 114 may not be stably formed, in the present embodiment, it is possible to fundamentally prevent this by providing the transferring step S24. Accordingly, it is possible to implement a desired design in response to various types of architectural forms.

The features, structures, effects and the like according to the above-described embodiments are included in at least one embodiment of the present disclosure, and are not necessarily limited to only one embodiment. Furthermore, the features, structures, effects, and the like illustrated in the embodiments may be combined or modified in other embodiments by those skilled in the art to which the embodiments belong. Accordingly, contents related to these combinations and modifications should be construed as being included in the scope of the present disclosure.

## Claims

1. A method for manufacturing a graphic cover substrate for a solar cell panel, comprising:
applying a cover layer, which is forming the cover layer composed of a ceramic material layer on a transfer member;
transferring, which is transferring the cover layer to a base member; and
reinforcing, which is forming a cover portion by reinforcing or semi-reinforcing the base member on which the cover layer is formed.

2. The method of claim 1, wherein the cover portion is composed of a ceramic oxide composition including a ceramic frit.

3. The method of claim 2, wherein the base member includes a glass substrate, and
the cover portion is composed of an integral part constituting a part of the glass substrate.

4. The method of claim 1, wherein in the applying the cover layer, the cover layer is formed by a printing process.

5. The method of claim 4, wherein in the applying the cover layer, the cover layer is formed by a digital inkjet printing process.

6. The method of claim 5, wherein the ceramic material layer includes a particle having a central particle diameter of 50 µm or more.

7. The method of claim 1, wherein a thickness of the cover portion is 20um or less.

8. The method of claim 1, further comprising:
forming, which is forming the base member between the transferring and the reinforcing.

9. The method of claim 1, wherein one surface of the base member on which the cover portion is formed has a curved, uneven, or protruding portion having a height difference of 5 µm or more.

10. A method for manufacturing a solar cell panel, comprising:
stacking, which is forming a stacked structure by stacking a first cover member, a first sealing material, a solar cell portion, a first sealing material, and a second cover member; and
laminating, which is integrating by applying heat and pressure to the stacked structure,
wherein the first cover member is formed by applying a cover layer, which is forming the cover layer composed of a ceramic material layer on a transfer member; transferring, which is transferring the cover layer to a base member; and reinforcing, which is forming a cover portion by reinforcing or semi-reinforcing the base member on which the cover layer is formed.

11. The method of claim 10, wherein the cover portion is composed of a ceramic oxide composition including a ceramic frit.

12. The method of claim 11, wherein the base member includes a glass substrate, and
the cover portion is composed of an integral part constituting a part of the glass substrate.

13. The method of claim 10, wherein in the applying the cover layer, the cover layer is formed by a printing process.

14. The method of claim 13, wherein in the applying the cover layer, the cover layer is formed by a digital inkjet printing process.

15. The method of claim 10, wherein a thickness of the cover portion is 20um or less.

16. The method of claim 10, further comprising:
forming, which is forming the base member between the transferring and the reinforcing.

17. The method of claim 10, wherein one surface of the base member on which the cover portion is formed has a curved, uneven, or protruding portion having a height difference of 5 µm or more.

18. A solar cell panel, comprising:
a solar cell;
a sealing material sealing the solar cell;
a first cover member positioned on one surface of the solar cell on the sealing material; and
a second cover member positioned on the other surface of the solar cell on the sealing material,
wherein the first cover member includes a base member having a curved, uneven, or protruding portion on one surface, and a cover portion formed on the one surface of the base member and made of an oxide ceramic composition.

19. The solar cell panel of claim 18, wherein a difference in height due to the curved, uneven, or protruding portion is 5 µm or more.

20. The solar cell panel of claim 18, wherein in the cover portion, a first transmittance, which is an average light transmittance of the cover portion with respect to light in an infrared region is equal to or greater than a second transmittance, which is an average light transmittance of the cover portion with respect to light in a visible light region.
